# EUROPEAN PATENT APPLICATION

(11) **EP 0 652 516 A1**
(43) Date of publication of application: **10.05.1995**
(21) Application number: 94307736.2
(22) Date of filing: 21.10.1994
(51) Int. Cl.: G06F 11/00

(54) **Integrated microprocessor**

(30) Priority: 03.11.1993 US 147695
(71) Applicant: ADVANCED MICRO DEVICES INC., Sunnyvale, California 94088-3453 (US)
(72) Inventor: Magnusson, Hans L., Buda, Texas 78610 (US); Gephardt, Douglas D., Austin, Texas 78748 (US); Mudgett, Dan S., Austin, Texas 78749 (US)
(74) Representative: Wright, Hugh Ronald

(57) **Abstract**

An integrated processor is provided wherein the layouts from a standalone microprocessor and one or more functional units are situated on a common semiconductor die and are linked by a common local bus. A testing circuit, also situated on the die and coupled to the common bus, is responsive to test command signals originating external to the integrated processor. When the testing circuit receives these externally originated command signals from a host computer, it generates local bus cycles which exercise the standalone microprocessor or the functional unit and/or devices attached thereto. In one embodiment, the integrated processor is incorporated on the motherboard of a target computer which is linked by a JTAG or other testing protocol bus to a host computer. The host computer generates the test command signals which are sent to and received by the testing circuit in the integrated processor. A debug memory space is reserved in the main system memory of the target computer for storage of debug software which is downloaded from the host computer. The debug software thus stored is executed when the processor on the target computer enters a debug mode.

## Description

This invention relates in general to microprocessors and, more particularly, to a type of microprocessor referred to as an "integrated microprocessor". An "integrated microprocessor" is a microprocessor in which an otherwise standalone microprocessor layout is integrated with other functional units on a common semiconductor die.

Over the years, microprocessors have become increasingly complex as they have progressed from early 8 bit implementations through later 16 bit, 32 bit and 64 bit implementations. At the same time that the data bandwidth of microprocessors has increased, the amount of functionality provided on a single semiconductor die has also substantially increased. For example, whereas the standalone Intel 386 microprocessor includes mainly a CPU and a memory management unit (MMU), in comparison the standalone Intel 486 microprocessor includes a CPU, a floating point unit (FPU), a cache and memory management unit (MMU) all located together on the same semiconductor die.

It is desirable to integrate the microprocessor even further by including such functional units as the interrupt controller, direct memory access (DMA) circuitry and memory controller all on the same semiconductor die together with the standalone microprocessor design layout. Microprocessors with such a very high degree of functional integration will be referred to as "integrated processors" or "integrated microprocessors". In other words, "integrated processors" are those processors which include a standalone microprocessor layout and one or more functional units all on the same semiconductor die.

Integrated processors present increased challenges to the microprocessor designer in terms of functional testability. In the case of older microprocessors, functional units such as DMA, the interrupt controller, the FPU, and others were located on a separately packaged chip or discrete circuitry separate from the microprocessor. In those cases, the functional unit was readily accessible for testing. However, when these functional units are integrated on a common semiconductor die in an "integrated processor", they are much less accessible to those involved in device and system testing.

It will be assumed that the integrated processor is intended for use as part of a larger functional structure such as a personal computer, workstation or other computing device. For convenience, the board on which the integrated processor is located will be called the motherboard, as is common practice. The processor is typically plugged into a dedicated processor socket on the motherboard.

One conventional approach for testing (or debugging) such a personal computer is the "in-circuit" emulator. In the case of the "in-circuit" emulator, instead of plugging the processor into the processor socket on the motherboard, an emulator circuit is plugged into that socket. Unfortunately, in this approach, the emulator circuit often has to be custom-designed for each particular personal computer motherboard on which it is to be used. Moreover, such "in-circuit" emulators often only fit pre-production models of a personal computer and not the final production model. Another disadvantage of such "in-circuit" emulators is that they take so long to build that they are often not available in the early part of the computer system design process. For this reason, "in-circuit" emulators are often not helpful in early system debugging. Moreover, "in-circuit" emulators for "integrated processors" tend to be extremely complex and expensive to build.

Boundary scan is another approach which permits testing of some of the components of a semiconductor device such as a microprocessor. In the boundary scan approach defined by IEEE Standard Test Access Port and Boundary-Scan Architecture, IEEE Std. 1149.1-1990, the peripheral border of a chip under test is provided with a plurality of interconnected boundary scan registers.

More particularly, a shift register stage is located adjacent each component pin of the device under test. In this manner, signals at component boundaries can be observed and controlled using scan testing techniques. A test vector is supplied to the boundary scan registers and the resultant output is compared with the expected output. Errors in the functioning of some of the components of the device may be determined in this manner. The protocol by which the tester communicates with the boundary scan registers is referred to as the JTAG (Joint Test Action Group) protocol. The IEEE 1149.1 standard defines a non-proprietary JTAG interface through which test signals using this testing protocol are transmitted.

Unfortunately, while boundary scan can be a helpful testing technique, it is a relatively slow technique which becomes even slower as the testing complexity increases on larger and more complex microprocessor devices such as "integrated processors". Another disadvantage of boundary scan testing is that it often does not provide full test information on all components of a device under test.

Testing or debugging of a microprocessor system, for example a personal computer using a microprocessor, can take many forms and can be viewed at many different stages of development. For instance, debugging of such a microprocessor system occurs prior to executing BIOS (before the system is bootable), during BIOS power on self test (but with no operating system loaded), after the operating system is loaded (but with no application software loaded), and after application software is loaded. (BIOS refers to the Basic Input Output System of a microprocessor system.) Debugging and testing of the integrated processor is desirable at all of these stages.

One conventional debugging approach is to load debugging software on the same microprocessor system which is being debugged. This approach assumes that the microprocessor system is in bootable condition which may not be the case in early system development. Another drawback with this approach is that the debugging software may have a resource conflict with the application software which the microprocessor system is running. In this situation, both the debugger software and the application software demand access to the same resource (memory, disk drive, etc.) at the same time. This problem can lead to system crashes and hinders the debugging and application testing process.

We will describe a debugging tool which is capable of testing the components of an integrated microprocessor under varied operating conditions.

We will describe a debugging tool which is capable of testing the CPU and functional units of an integrated processor at the various stages of microprocessor system development, that is, from prior to achievement of system booting all the way through operating system load and application software development.

We will describe a debugging tool which operates at relatively high speed while testing an integrated processor.

We will describe a debugging tool for integrated processors which does not require a special custom-made connector or test rig for each integrated processor designed.

We will describe a debugging tool which is avoids resource conflicts during debugging of application software.

In accordance with one embodiment of the present invention, a microprocessor with built-in testing capability is provided. More particularly, the disclosed microprocessor includes a semiconductor die and a central processing unit situated on the die. The microprocessor also includes a local bus which is situated on the die and coupled to the central processing unit. The microprocessor further includes at least one functional unit situated on the die and coupled to the local bus. A testing circuit is situated on the die and is coupled to the local bus. The testing circuit initiates a bus cycle for testing purposes in response to a test command originating external to the microprocessor.

### BRIEF DESCRIPTION OF THE DRAWINGS

The features of the invention believed to be novel are specifically set forth in the appended claims. However, the invention itself, both as to its structure and method of operation, may best be understood by referring to the following description and accompanying drawings.

FIG. 1 is a block diagram of an integrated microprocessor including a hardware/software debugging tool.

FIG. 2 is a block diagram of a target computer system employing the integrated microprocessor of FIG. 1 shown together with a host computer.

FIG. 3 is a block diagram of the hardware/software debugging tool of FIG. 1.

FIG. 4 is a JTAG state diagram which depicts the operation of the TAP controller used by the debugging tool.

FIG. 5 is a block diagram of the timing and control circuit of the debugging tool of FIG. 3.

FIG. 6 is a state diagram which depicts the operation of the bus cycle state machine employed by the hardware/software debugging tool.

FIG. 7 is a memory map of the memory space employed by the hardware/software debugging tool.

FIG. 8 is a block diagram of the arbitration portion of the integrated processor.

FIG. 9A-9B are flowcharts which together depict the operational flow of the debugging tool of the present invention.

FIG. 10 is a representation of the pin-out of the debugging tool of the invention.

FIG. 11A is a timing diagram depicting a memory read cycle in normal mode.

FIG. 11B is a timing diagram depicting an I/O read cycle in normal mode.

FIG. 11C is a timing diagram depicting a memory write cycle in normal mode.

FIG. 11D is a timing diagram depicting a memory write cycle in system debug mode.

FIG. 11E is a timing diagram depicting a memory write cycle in system management mode (SMM).

### I. Operational Environment

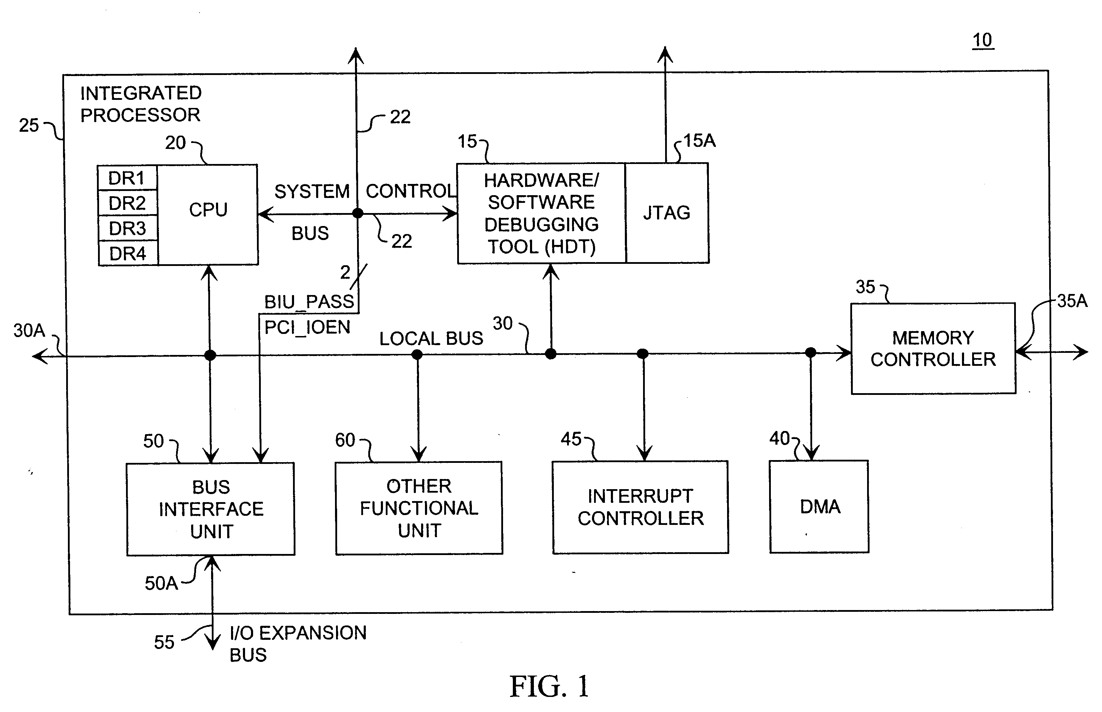

FIG. 1 is a block diagram of an integrated microprocessor 10 in which the hardware/software debugging tool (HDT) 15 of the present invention is employed. Integrated processor 10 includes a standalone central processing unit (CPU) 20 which is situated on semiconductor die 25. The term "standalone" is used here to indicate that the layout from a standalone CPU such as an Advanced Micro Devices, Inc. Am386 or Am486 microprocessor, for example, is fabricated on semiconductor die 25. Whereas such microprocessor devices are normally used in standalone fashion surrounded by various support chips, in the present invention the layout from such a standalone microprocessor is incorporated on die 25 along with HDT 15 and other structures.

As seen in FIG. 1, a local bus 30 couples CPU 20 to HDT 15. Other functional units which normally reside in standalone chips separate from the CPU, such as memory controller 35, direct memory access (DMA) controller 40, interrupt controller 45 and bus interface unit 50, are also coupled to local bus 30 on die 25. A local bus port 30A is provided for interfacing external devices to local bus 30.

An expansion bus port 50A is provided to bus interface unit 50 for connecting external input/output (I/O) devices to microprocessor 10 via an expansion I/O bus 55. In one embodiment, expansion bus 55 is a PCI (Peripheral Component Interconnect) bus as set forth in the PCI Special Interest Group specification for that bus. Expansion bus 55 bus can also be an Industry Standard Architecture (ISA) bus, an Extended Industry Standard Architecture (EISA) bus, a Micro Channel bus (Micro Channel is a trademark of the IBM Corporation) or other I/O bus. For purposes of this document, a peripheral device is defined as a functional unit which is located external to the microprocessor.

A memory port 35A is provided to memory controller 35 to permit memory such as dynamic random access memory (DRAM) or erasable programmable read only memory (EPROM) to be coupled to memory controller 35. As indicated by the functional unit designated "other functional unit" 60, other functional units not listed above could also be incorporated in microprocessor 10 and be coupled to local bus 30.

As seen in FIG. 1, HDT 15 includes a JTAG interface (or JTAG port) 15A for coupling HDT 15 to a host unit 200 over a JTAG bus. The JTAG interface is defined by IEEE Standard 1149.1.

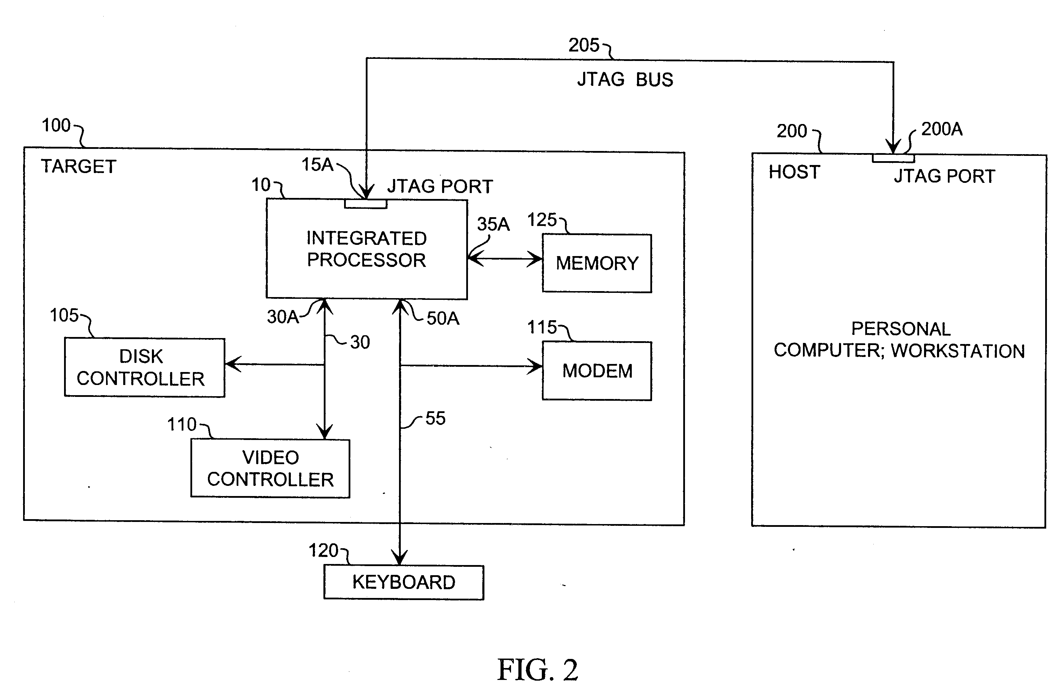

In actual practice as shown in FIG. 2, microprocessor 10 is situated on a motherboard 100 which is also referred to as target system 100. Target system 100 communicates with a host system 200 during system testing. Target system 100 includes a disk controller 105 and a video controller 110 coupled to local bus 30 via local bus port 30A. A modem 115 and a keyboard or other input device 120 are coupled to I/O port 50A via I/O expansion bus 55. A random access memory 125, such as a DRAM memory for example, is coupled to memory controller port 35A as shown.

Target system 100 is the system for which testing and debugging is desired at the multiple stages of system development. To accomplish this testing, target system 100 is coupled to host system 200. More particularly, the JTAG port 200A of host 200 is coupled to JTAG port 15A of target 100 over a JTAG bus 205. In this manner, test commands can be sent from host 200 to the integrated processor 10 of target system 100 to exercise and test the components of processor 10 and target 100. Responsive test data is then sent back to host 200. In one embodiment of the invention, host system 200 is an IBM compatible personal computer or other platform onto which debugging software can be loaded. It should be noted that the target system 100 under test is separate and distinct from the host system 200 which will initiate and control the testing of target system 100.

### II. Hardware/Software Test Tool - Basic Layout And General Operation

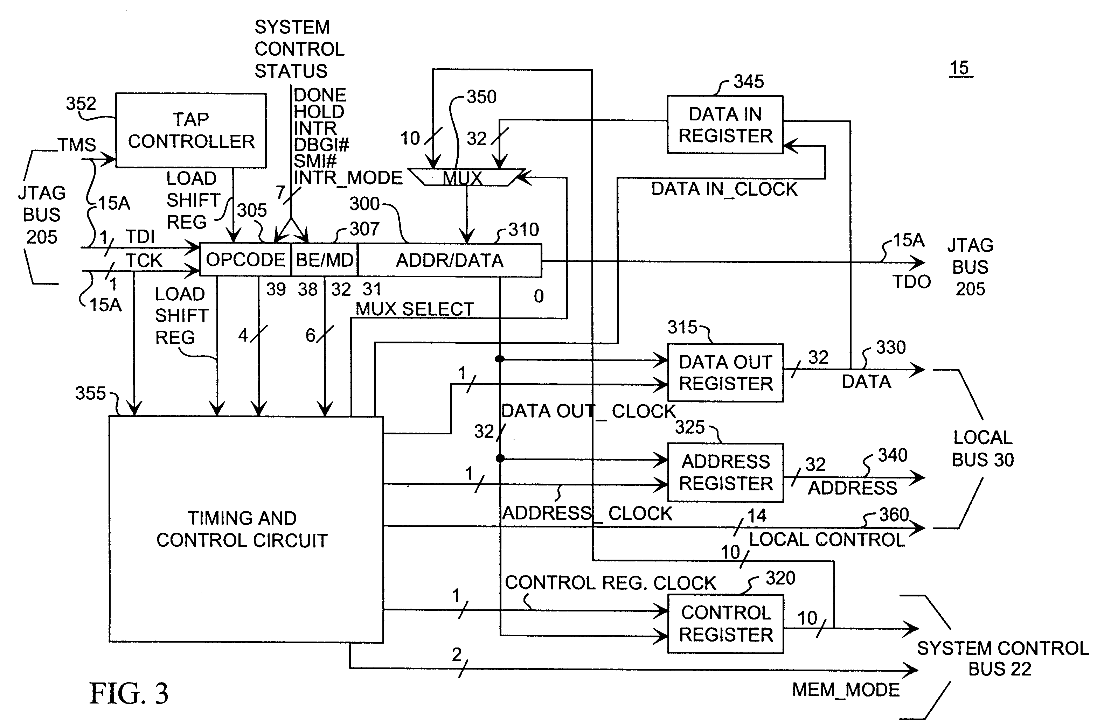

A simplified block diagram of HDT 15 is shown in FIG. 3. In FIG. 3, bus widths are indicated by a hash mark crossing the bus. The number of bits associated with a bus are indicated adjacent the hash mark as per normal convention. The TDI, TMS, TCK inputs and the TDO output of HDT 15 together form the JTAG port 15A of HDT 15. The TDI input of HDT 15 is the JTAG data input through which information (including commands, instructions and data) are sent to HDT 15 from host system 200. The TMS input is a control input which informs HDT 15 how to interpret data input as per the IEEE Standard Test Access Port (TAP) and Boundary-Scan Architecture, IEEE Std. 1149.1-1990, which is incorporated herein by reference. The TCK input of HDT 15 is the JTAG clock input through which a clocking signal is provided to HDT 15 by host system 200. The TDO output of HDT 15 is the JTAG data output through which responsive test data, results and status information are sent from HDT 15 back to host system 200. The protocol of the signals on the TDI, TMS, TCK and TDO lines are all defined in the above-cited IEEE 1149.1 standard.

The TDI and TCK inputs of HDT 15 are coupled to the input of a shift register 300 which includes an OPCODE portion 305, a BE/MD portion 307 and an ADDR/DATA portion 310. In one embodiment of the invention, shift register 300 is 50 bits wide to accommodate a 50 bit wide command from host 200. This bit width is allocated as follows: 4 bits to the opcode, 6 bits to the BE/MD information, 32 bits to the address or data, and 8 bits to guard bits for the command.

Shift register 300 is a serial in/parallel out - parallel in/serial out shift register. When a command is shifted into shift register 300 serially from the JTAG TDI data input line, the opcode portion of the command resides in the opcode portion 305 of register 300. The opcode is provided to timing and control circuit 355 via a 4 bit wide parallel output of opcode portion 305 as shown. Control circuit 355 causes the appropriate bus cycle signals to be generated on local bus 30 so that the particular operation specified in the command's opcode is performed. More specifically, control circuit 355 issues the appropriate control signals on local control bus 360 which is part of local bus 30 as seen in FIG. 3. In this manner, the specified bus cycle is generated.

The address or data information from the command is forwarded from ADDR/DATA portion 310 to address bus 340 and data bus 330, respectively. The bus cycle specified is carried out and the result is returned over local bus 30 back to ADDR/DATA portion 310. The result in ADDR/DATA portion 310 is forwarded back to host 200 over JTAG bus 205.

To summarize, the opcode received by OPCODE portion 305 defines the task to be performed by HDT 15. The output of shift register 300 is the TDO data output of HDT 15 at which results or responses to the commands are sent via JTAG bus 205 back to the host 200. The BE/MD portion 307 serves as a placeholder for Byte Enable (BE) and Mode (MD) information associated with a particular command. The ADDR/DATA portion 310 holds the Address (ADDR) or Data (DATA) information of a received command as it is shifted into shift register 300 from the TDI data input line. The ADDR/DATA portion 310 also stores the result of the command as it comes back over local bus 30. After the result information is received back in ADDR/DATA portion 310, it is shifted out the TDO data output line back to the host via JTAG bus 205.

### III. Hardware/Software Test Tool - Detailed Operation BUILT-IN COMMANDS; CONTROL COMMANDS

Shift register 300 is coupled to a "data-out" register 315, to control register 320 and to address register 325 as shown in FIG. 3. The output of data-out register 315 is coupled to a data bus 330 (D31:D0) within local bus 30. The output of control register 320 is coupled to system control bus 22 which communicates system control information between CPU 20 and HDT 15. The output of address register 325 is coupled to an address bus 340 within local bus 30.

HDT 15 includes a "data-in" register 345 which is coupled between the data bus 330 of local bus 30 and one input of a two input multiplexer (MUX) 350. Data-in register 345 receives result data back from the local bus in response to commands and provides that result data to multiplexer 350. The second input of multiplexer 350 is coupled to the system control bus 22. More specifically, the output of control register 320 is coupled to the second input of multiplexer 350 such that the control bits stored in control register are provided to multiplexer 350. In this manner, either input data from local data bus 330 or a snapshot of current system control bus information from system control bus 22 is provided to MUX 350 for transmission back to host 200. The output of MUX 350 is coupled to the ADDR/DATA portion 310 of shift register 300. The information stored in ADDR/DATA portion 310 and the remainder of shift register 300 is shifted out to JTAG bus 205 for reception by host 200.

While many different commands can be provided to HDT 15 to cause different local bus cycles and other system level functions to be performed, such as writing and reading particular memory locations, a simplified illustrative example is now discussed wherein the host 200 issues a command for a read cycle. The read command includes a "read" opcode portion and an address portion which specifies the memory address from which a read is desired. The read command is communicated to HDT 15 over the JTAG bus 205. The read command is shifted into shift register 300 bit by bit at a rate determined by clocking signal TCK.

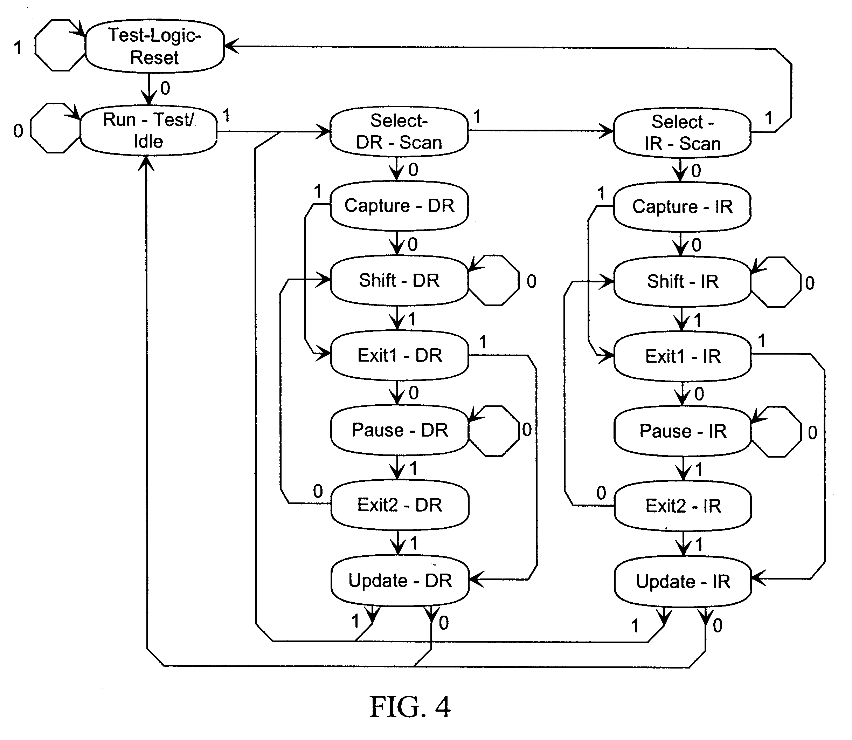

A test access port (TAP) controller 352 is coupled to shift register 310 to control the transfer of input information from host 200 to HDT 15 via the JTAG bus 205. TAP controller 352 is of the type specified by the IEEE Standard Test Access Port (TAP) and Boundary-Scan Architecture, IEEE Std. 1149.1-1990. More particularly, TAP controller 352 is a synchronous finite state machine which responds to changes in the TMS and TCK signals of the JTAG bus. The TMS (test mode select) input to TAP controller 352 receives a TMS signal which is decoded by TAP controller 352 to control test operations. The state diagram for TAP controller 352 as per IEEE Std. 1149.1 is shown in FIG. 4. In FIG. 4, the value shown next to each state transition represents the signal present at the TMS pin at the time of a rising edge of clock TCK. More information with respect to TAP controller 352 is found in Chapter 5 of IEEE Std. 1149.1. The state diagram shown shown in FIG. 4 is also referred to as the JTAG state machine.

When the opcode portion and address portion of the command, together with the BE/MD portion, have been fully clocked into shift register 300, a Load Shift Register signal is generated and the opcode portion or opcode of the command is provided to timing and control circuit 355. Data, namely commands, are written from host 200 to HDT 15 while HDT 15 is in an "Update-DR" state under the control of TAP controller 352, and return data are written back to host 200 in a "Capture DR" state both under the control of TAP controller 352 as per the cited IEEE Std. 1149.1-1990 specification and as seen in the state diagram of FIG.4. Read data are captured during the "Capture_DR" state and shifted out during the "Shift-DR" state. Write data are shifted in during the "Shift-DR" state and written during the "Update-DR" state.

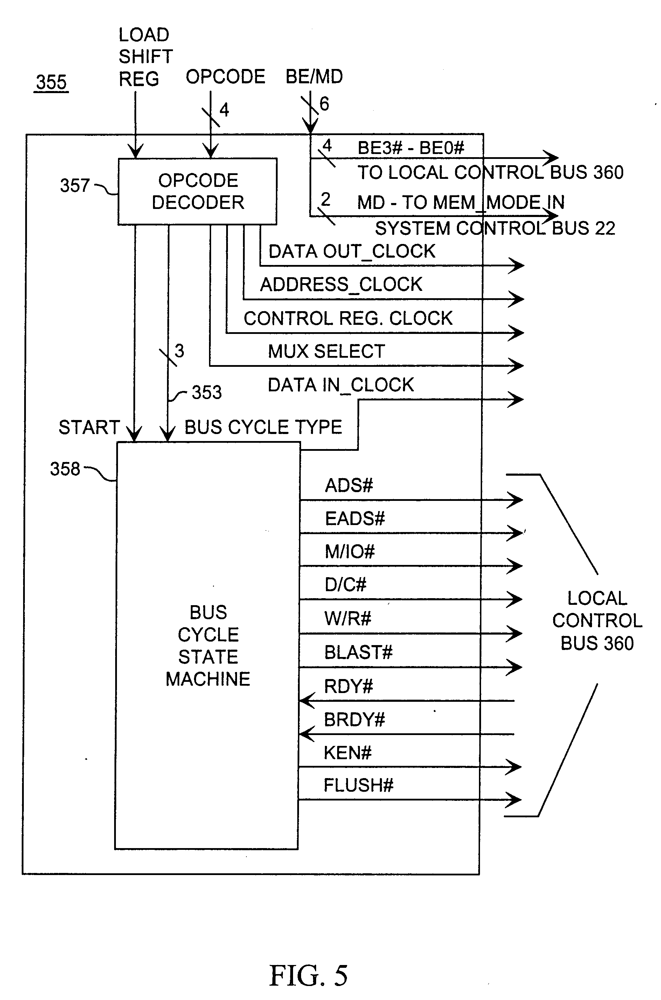

As shown in FIG. 5, control circuit 355 includes an opcode decoder 357 which decodes the particular opcode (in this example, a read opcode) provided by opcode portion 305. The LOAD SHIFT REGISTER signal from TAP controller 352 informs opcode decoder 357 of the fact that a new command including opcode, BE/MD and ADDR/DATA portions has been fully shifted into shift register 300 and is ready for processing.

Opcode decoder 357 is coupled to shift register opcode portion 305 (see FIG. 3) to receive the opcode of each command sent to HDT 15 from host 200 via the JTAG bus 205. Each command includes an opcode field, a BE/MD field and an ADDR/DATA field. Opcode decoder 357 decodes the particular opcode (opcode field) and issues a Bus Cycle Type signal over type bus 353 to a bus cycle state machine 358. Opcode decoder 357 assigns values to the Bus Cycle Type signal according to the particular type of opcode loaded in shift register 300. In one embodiment, type bus 353 is 3 bits wide and is capable of specifying 8 different types of commands.

In one example, if the opcode corresponding to a read memory bus cycle is received by opcode decoder 357, then decoder 357 sends a read memory type signal to the bus cycle type input of bus cycle state machine 358. If the opcode corresponding to an I/O read bus cycle is received by opcode decoder 357, then decoder 357 sends an I/O read type signal to state machine 358.

Several typical commands which are transmitted to HDT 15 for decoding and processing are listed below in TABLE 1. The following commands correspond to the different types of bus cycles or activities which can be initiated for testing purposes in accordance with the present invention. These commands are alternatively referred to as built-in commands.

**TABLE 1**

| BUILT-IN COMMANDS | |
|---|---|
| Command Format | Command Name |
| 00 0000 0000 [Null] | No Operation (NOP) |
| 00 1000 0000 [Null] | Select Control Register |
| 00 1100 0000 [Null] | Select Data Register |
| 01 0000 0000 [Data] | Write Control Register |
| 01 1000 0000 [Data] | Write Data Register |
| 10 00MD -BE- [Addr] | Generate Interrupt Acknowledge Cycle |
| 10 01MD -BE- [Addr] | Generate Special Cycle |
| 10 10MD -BE- [Addr] | Generate I/O Read Cycle |
| 10 11MD -BE- [Addr] | Generate I/O Write Cycle |
| 11 00MD -BE- [Addr] | Generate Memory Code Read Cycle |
| 11 10MD -BE- [Addr] | Generate Memory Data Read Cycle |
| 11 11MD -BE- [Addr] | Generate Memory Data Write Cycle |

The Byte Enable (BE) field of the command format indicates the particular bytes to be written or read for the particular accessed word. On writes, the selected bytes are written. On reads, the memory controller ignores the byte enable and reads all bytes of the word. An example of a special cycle listed in Table 1 is the conventional halt cycle. The byte enables and address (A1,A0) contain one of the legal combinations in Table 2 below: In Table 2, A1 and A0 are the two lowest order bits of the address referenced in the read or write.

**Table 2**

| BYTE ENABLE (BE) FIELD OF THE BUILT-IN COMMAND | | |
|---|---|---|
| Byte Enable | Address (A1,A0) | Cycle Type |
| 1110 | 00 | One byte at address 00 |
| 1100 | 00 | Two bytes at address 00 |
| 1000 | 00 | Three bytes at address 00 |
| 0000 | 00 | Four bytes at address 00 |
| 1101 | 01 | One byte at address 01 |
| 1001 | 01 | Two bytes at address 01 |
| 0001 | 01 | Three bytes at address 01 |
| 1011 | 10 | One byte at address 10 |
| 0011 | 10 | Two bytes at address 10 |
| 0111 | 11 | One byte at address 11 |

On special bus cycles, the byte enables (BE's) identify the type of cycle being performed as per Table 3 below:

**Table 3**

| SPECIAL CYCLES INDICATED BY BYTE ENABLES | | |
|---|---|---|
| BE(3:0) | Special Cycle Type | Byte Lane For Other Cycles |
| 1110 | Shutdown | Data (07:00) |
| 1101 | Cache Flush | Data (15:08) |
| 1011 | Halt | Data (23:16) |
| 0111 | Cache Write Back | Data (31:24) |

The MD field (mode field) identifies the type of address space to be employed for a particular memory read or write operation as seen below in Table 4. (For I/O accesses the MD field is a don't care.) More particularly, the MD field specifies whether the address space employed is normal memory, system management mode memory or system debug mode memory.

**Table 4**

| MODE (MD) FIELD OF THE BUILT-IN COMMAND | |
|---|---|
| MD | Address Space |
| 00 | Normal Memory |
| 01 | System Management Mode (SMM) |
| 10 | System Debug Mode |
| 11 | Illegal |

It is noted that the commands of Table 1 are "built-in commands" in that they are hard-coded into state machine 358. These commands can advantageously be executed without the involvement of the CPU. In other words, bus cycles and I/O activities can be performed without CPU involvement. More particularly, main memory reads and writes as well as I/O reads and writes are desirably performed for testing purposes without CPU involvement. For this reason, HDT 15 is particularly effective in debugging partially operational computer systems or computer systems in the early stages of system development.

In actual practice, a read local bus cycle is implemented in the following fashion. The read data local bus cycle is initiated by sending a sequence of two commands to HDT 15 for decoding by opcode decoder 357 and processing by state machine 358 (FIG. 5). A Generate Memory Data Read Cycle command, namely 1110MD-BE-[Addr] as set forth in Table 1, is first sent to HDT 15. This read command is shifted into register 300. In so doing, the read opcode resides in opcode portion 305, the BE/MD information resides in BM/MD portion 307 and the specified address to be read resides in ADDR/DATA portion 310.

Opcode decoder 357 decodes the read opcode and communicates decoded read opcode information (bus cycle type) to state machine 358. An address clock pulse is issued to address register 325 to load the address specified in the read memory command from ADDR/DATA portion 310 into address register 325. State machine 358 generates standard local bus control signals to cause the specified local bus operation, here a memory read, to be performed. The data stored at the specified memory address then comes back over the data bus 330 of local bus 30 as result information or return data. A data-in clock pulse is issued to data-in register 345 to cause the return data to be loaded into data-in register 345.

To recapitulate, when a particular command (opcode) is decoded, state machine 358 generates the corresponding appropriate local bus signals for carrying out that specified type of local bus cycle as set forth in the Am486 DX/DX2 Microprocessor Hardware Reference Manual published by Advanced Micro Devices, Rev. 1, 1993, the disclosure of which is incorporated herein by reference. More particularly, bus cycle state machine 358 of FIG. 5 generates the appropriate standard local bus control signals as follows: ADS#, EADS#, M/IO#, D/C#, W/R#, BLAST#, RDY#, BRDY# to initiate a read as per the above manual.

It is noted that in one embodiment of the invention, when memory reads are performed, all four bytes which are specifiable by the byte enables (BE0-BE3 of the BE/MD field of the command), are received whether specified or not by the byte enables. However, when memory writes are performed, the particular byte or bytes specified by the BE/MD field are written.

To complete the memory read, host 200 sends HDT 15 a second command, namely a Select Data Register command having an opcode 0011 as seen in Table 1. This command causes the MUX SELECT signal to instruct MUX 350 to use data-in register 345 as its input. The output of MUX 350 is coupled to the input of ADDR/DATA portion 310 of shift register 300. In this manner, the return data in data-in register 345 is provided by MUX 350 to ADDR/DATA portion 310. When the next command from host 200 is shifted into shift register 300 via input TDI, the return data in ADDR/DATA portion 310 is serially shifted out of register 300 to the TDO output 15A. The return data is then communicated over JTAG bus 205 back to host 200. It is noted that if a series of read commands are going to be strung together, then the next read command in the series will cause the return data from the immediately prior read to be shifted out of shift register 300 to TDO. Advantageously, in the case of a series of reads, the Select Data Register need not be selected after each read since the data-in register 345 will remain selected until otherwise instructed.

Opcode decoder 357 includes an output which is coupled to the START input of bus cycle state machine 358 so that a START signal can be sent from opcode decoder 357 to state machine 358. In this manner, state machine 358 is apprised of the fact that a decoded opcode has been transmitted to the Bus Cycle Type input of the state machine and that it is now time for the state machine to generate the requested bus cycle.

While the generation of a read memory local bus cycle has been discussed above, many other different types of bus cycles can be performed using the described testing technique. Reads/writes (R/W) to memory, R/W to peripherals (I/O devices), and also R/W to devices on a PCI expansion bus 55, interrupt acknowledge, the special bus cycles in Table 3 and other bus cycles can be performed. It is noted that these bus cycles can be performed when the system is in either NORMAL or DEBUG mode. When HDT 15 is initiating bus cycles for testing purposes, HDT 15 is said be operating in a bus cycle mode which may be a part of either NORMAL or DEBUG mode operations.

The generation of a write memory local bus cycle is now discussed for example purposes. To initiate a write memory cycle, host 200 first sends a Write Data Register command (see Table 1) to HDT 15. Once this write command is shifted into shift register 300, the opcode resides in opcode portion 305 and the data resides in ADDR/DATA portion 310. The write opcode within the command is decoded by opcode decoder 357 and write data register type information is sent to state machine 358. The Write Data Register command requires no action by state machine 358 in terms of generation of local bus signals. State machine 358 waits for further instruction. A data-out clock signal is issued which causes the data in ADDR/DATA portion 310 to be loaded into data-out register 315.

A second command is then sent by HDT 15 to complete the desired memory write operation. More particularly, a Generate Memory Data Write command (see Table 1) is sent to HDT 15. This write command includes both a memory data write opcode as well as the address to which the already loaded data is to be written. The memory date write opcode is provided to opcode decoder 357 which decodes the opcode and provides memory data write type information to state machine 358. An address clock signal is generated by timing and control circuit 355 to load the address which is present in ADDR/DATA portion 310 into address register 325. State machine 358 generates the appropriate standard local bus signals to cause the specified write memory local bus cycle to be performed on local bus 30. When the local bus cycle is completed, the data stored in data-out register 315 is stored in memory at the address contained in address register 325.

It is noted that opcode decoder 357 generates the following clock signals: data-in clock, data-out clock, address clock and control reg. clock which are respectively supplied to data-in register 345, data-out register 315, address register 325 and control register 320. The data-in clock signal is generated by state machine 358 and is provided to data-in register 345. In one case, the data-in clock signal pulse is generated after the specified read or write bus cycle is performed to load data-in register 345 with the present data on local bus 30. The data-out clock signal pulse is generated when a Write Data Register command is decoded by opcode decoder 357 to load data-out register 315 with the present data contents of ADDR/DATA portion 310 of shift register 300. The control register clock signal pulse is generated when opcode decoder 357 decodes a Write Control Register command. The address clock signal pulse is generated when opcode decoder decodes one of the last seven commands in Table 1, namely those commands in Table 1A below:

**Table 1A**

| | |
|---|---|
| 10 01MD -BE- [Addr] | Generate Special Cycle |
| 10 10MD -BE- [Addr] | Generate I/O Read Cycle |
| 10 11MD -BE- [Addr] | Generate I/O Write Cycle |
| 11 00MD -BE- [Addr] | Generate Memory Code Read Cycle |
| 11 01MD -BE- [Addr] | Reserved Cycle |
| 11 10MD -BE- [Addr] | Generate Memory Data Read Cycle |
| 11 11MD -BE- [Addr] | Generate Memory Data Write Cycle |

Bus cycle state machine 358 of control circuit 355 generates bus transactions on local bus 30 as requested by the external host 200. Once a particular command is decoded, that is, its opcode is discerned by opcode decoder 357, opcode decoder 357 issues a START signal to bus cycle state machine 358. To actually start the particular type of bus cycle which is specified to state machine 358 by opcode decoder 357 via the bus cycle type signal, state machine 358 asserts a signal HDT_HOLD to the arbiter port of integrated processor 10.

In addition to responding to the built-in commands of Table 1 which result in the generation of the local bus cycle specified by the command, HDT 15 also responds to the HDT control commands listed below in Table 5.

**Table 5**

| HDT CONTROL COMMANDS (CONTROL REGISTER 320 PINOUT) | | |
|---|---|---|
| System Control Bus 22 Bit(s) | Name | Description (Command Function) |
| 9 | CPUCYC | Execute a CPU single step |
| 8 | STOPCPU | Stop the CPU |
| 7 | RESET | Reset the System |
| 6 | RESCPU | Reset the CPU |
| 5 | ENAPCI | Enable PCI access to internal registers (aka. PCI_IOEN) |
| 4 | DSPCYC | Display all cycles on the PCI bus (Expansion Bus 55 is a PCI bus in one embodiment.) (aka. BIU_PASS) |
| 3 | FLUSH | Flush the CPU cache (aka. FLUSH#) |
| 2 | DISABLE | Disable the CPU cache (aka. KEN# to CPU) |
| 1 | DBGINTR | Generate a DEBUG INTERRUPT (aka. DBGI# to CPU) |
| 0 | HDTENA | Enable all Hardware Debug Functions |

The HDT control commands are carried out by raising selected bit positions within address/data portion 310 to a high state. The bit position within address/data portion 310 which is thus raised high causes a respective bit position within control register to change state. This change of state of a bit position within control register 320 causes a corresponding state change in a respective control line in system control bus 22 to initiate the desired command function.

For example, should the user of the system desire to Reset The System, the user instructs host 200 to send a Write Control Register command which includes a Write Control Register opcode and an HDT control command for RESET encoded in the address/data portion of the Write Control Register command. The RESET command is transmitted over JTAG bus 205 as a bit pattern included within the Write Control Register command wherein position 7 of the address/data portion is high. The bit pattern of the command is shifted into shift register 300 and causes the state of the bit in bit position 7 (see Table 5) of address/data portion 310 to go high. When state machine 358 receives a Write Control Register type from opcode decoder 357, state machine 358 issues a control register clock signal to control register 320. This causes the bit pattern contained in address/data portion 310 to be impressed on system control bus 22 such that a corresponding line 7 (RESET line) in system control bus 22 change state. This action on system control bus 22 causes CPU 20, which is coupled thereto, to initiate a system reset.

If a "CPU cache flush" is desired, then a Write Control Register command including a bit pattern with position 3 being high in the address/data portion thereof is transmitted from host 200 to HDT 15. If a "generate a debug interrupt command" is desired, then a Write Control Register command including a bit pattern with position 1 being high in the address/data portion thereof is transmitted to HDT 15, and so forth in a similar manner with the remaining commands of Table 5.

In more detail, in the case where the test operator desires to flush the CPU cache (not shown separately, but included within CPU 20), a Write Control Register command with the HDTENA and FLUSH bits set (namely bits 0 and 3, respectively of the bit pattern) is sent from host 200 to HDT 15 over JTAG bus 205. In the case of such a cache FLUSH command, the command includes a set bit at position 0 which enables the HDT when the corresponding line of system control bus 22 is caused to change state by control register 320. The command also includes a set bit at position 3 which initiates the cache flush when the corresponding line of system control bus 22 is caused to change state by control register 320. In the present example, the data portion of the command includes a bit pattern wherein data bit 0 and 3 are set and the remaining data bits are not set.

When an HDT command such as the FLUSH command is transmitted within a Write Control Register command to shift register 300 of HDT 15, the opcode portion (Write Control Register) of the Write Control Register command appears in opcode portion 305 of shift register 300. The data of the Write Control Register command, namely the HDT control command bit pattern which indicates the FLUSH, appears in data portion 310. A control register clock signal pulse is generated when the Write Control Register command is received and decoded by HDT 15. The control register clock pulse causes the bit pattern in data portion 310 to be loaded into control register 320 and to be supplied to system control bus 22. A FLUSH of the CPU cache thus results when the bit pattern of the HDT control command is impressed on system control bus 22 by control register 320. The remainder of the control commands of Table 5 are carried out in a similar manner. Whereas the built-in commands discussed earlier require no CPU involvement, the HDT control commands of Table 5 do require CPU action.

The manner in which a "snapshot" of selected signals on system control bus 22 is sent back to host 200 is now discussed. The two input multiplexer 350 provides either return data/result information from data-in register 345 or a read back of the contents of control register 320 with the upper 22 bits cleared to zero in the ADDR/DATA portion 310. When HDT 15 receives a Select Control Register command from HDT 15, a MUX SELECT signal is generated which causes MUX 350 to use the ten (10) lines from control register 320 as its input rather than data-in register 345. The read back of the contents of control register 320 reflects the particular bit pattern or value loaded therein by the last Write Control Register command. Each bit stored in a bit position of control register 320 corresponds to a different system function as per Table 5. Thus, sending these contents of control register 320 back to host 200 via MUX 350, address/data portion 310 and via JTAG bus 205 provides a "snapshot" of the system status to the user of host 200.

It is noted that additional system status information is transmitted back to host 200 each time shift register 300 transmits its address/data portion 310 contents (bits 0-31) back to host 200. As seen in FIG. 3, the DONE, HOLD, INTR, DBGI#, SMI# and INTR_MODE (2 lines) lines are coupled to opcode portion 305 and BE/MD portion 307. The signal lines are coupled to respective bit positions within shift register 300 according to Table 5A below:

**Table 5A**

| SYSTEM CONTROL STATUS | | |
|---|---|---|
| Bit(s) | Name | Description |
| 38 | DONE | Requested Bus Cycle Complete |
| 37 | HOLD | Hold Request Is Pending |
| 36 | INTR | Maskable Interrupt Is Pending |
| 35 | DBGI# | Debug Interrupt Is Pending |
| 34 | SMI# | System Management Interrupt Is Pending |
| 33,32 | INTR_MODE | Type Of Memory Space Used By Current Memory Cycle |
| | | System interrupt mode of the CPU |
| | | 00 Normal |
| | | 01 System Management Mode |
| | | 10 System Debug Mode |
| | | 11 System Debug Mode entered from System Management Mode. |
| 0-31 | DATA or CONTROL REGISTER CONTENTS | Returned result data or control register status. (Right justified in 32-bit field. Unused bits are zero.) |

When the next command from host 200 is received by HDT 15, the contents stored in ADDR/DATA portion 310 (whether it be returned data or control register contents) are shifted out to TDO and to host 200 via JTAG bus 205. Together with these ADDR/DATA portion 310 contents, the contents of opcode portion 305 and BE/MD portion 307 are shifted out to TDO and to host 200 as well. In this manner, a snapshot of the current state of the 6 system control signals DONE, HOLD, INTR, DBGI#, SMI# and INTR_MODE is provided to host 200 with each transmission of return data.

Examining these 6 system control bus signals in this manner permits the test operator to determine if a system management interrupt is pending (see SMI# in the snapshot), to determine if an interrupt is pending (see INTR in the snapshot), to determine if a hold is pending (see HOLD in the snapshot), or to determine the current state of the microprocessor, namely, normal or system management mode (see INTR_MODE in the snapshot). It is noted that the snapshot can also be examined to determine whether or not a debug interrupt is pending (see DBGI# in the snapshot). HDT 15 also drives the MEM_MODE lines in system control bus 22 to cause each memory cycle to be directed to the appropriate memory space, namely to normal memory space, system management memory space or special debug memory space. In other words, the two dedicated MEM_MODE signal lines specify the operating mode of the current memory cycle.

The symbol # in a particular signal indicates that the subject signal is active low. It is noted that "Data" as set forth at the end of Table 5A refers to the 32 bits of data captured by HDT 15 from local bus 30 in the course of testing.

The signal INTR_MODE refers to the current state in which processor or CPU 20 is operating. The INTR_MODE signal may assume four different states or modes, namely, Normal Mode, System Management Mode, System Debug Mode and System Debug Mode entered from System Management Mode. Normal Mode is defined as the operating state for operating systems and software applications code. System Management Mode refers to the operating state provided in the Am486 microprocessor for power management code. System Debug Mode is the operating state for debug code employed in the present invention.

SMI# is the signal to the processor or CPU 20 from circuitry external to the processor (for example, an external power management controller) that indicates that a system management interrupt is requested. DBGI# is the signal to the processor or CPU 20 from the HDT which indicates that a debug interrupt is requested. INTR is the standard interrupt request signal to the processor. HOLD is the hold request signal to the processor.

The above-described system status signals of Table 5A are captured as a snapshot of the current state of the internal signals with the listed names. This "data" (return data or result information) is sent out through the TDO line as new JTAG data is sent into the TDI line to HDT 15 from host 200. It is again noted that the DONE, HOLD, INTR, DBGI#, SMI# and INTR_MODE signals are JTAG status signals.

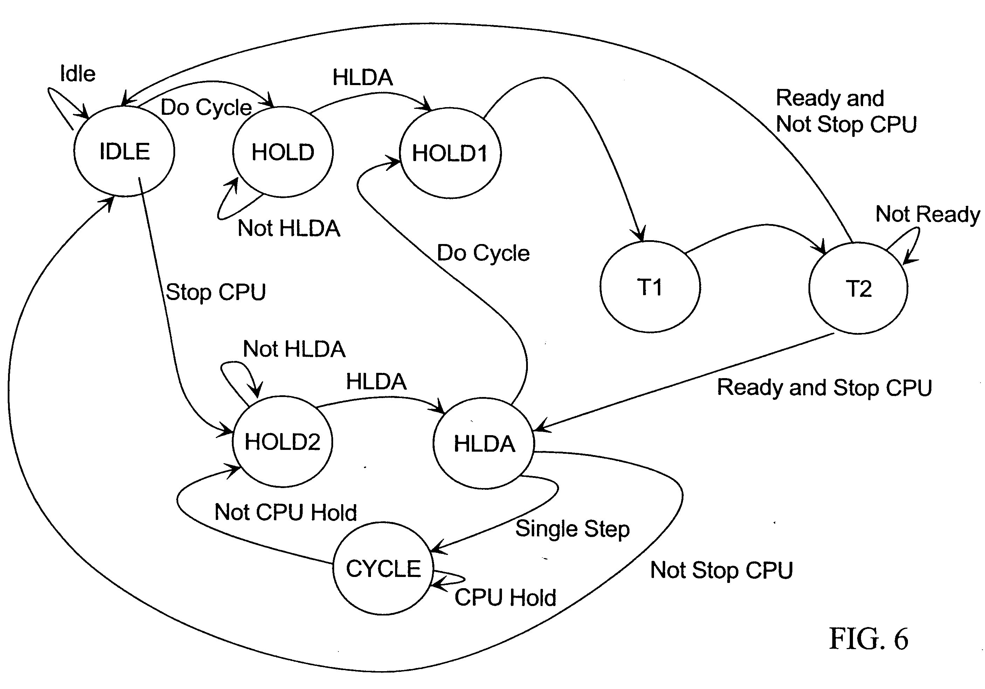

The state diagram for one state machine which may be employed as bus cycle state machine 358 is shown in FIG. 6. State machine 358 is a synchronous state machine which includes eight states, namely the IDLE state, the HOLD state, the HOLD1 state, the HOLD2 state, the HLDA state, the CYCLE state, the T1 state and the T2 state. As seen in FIG. 6, the state diagram includes four major sequences, namely generate a bus cycle, stop the CPU, single bus cycle step of the CPU and generate a bus cycle from a stopped CPU.

Bus cycle state machine 358 is reset at power-on to the IDLE state. The state machine is also held in the IDLE state during those times when the JTAG state machine of FIG. 4 is in the Test-Logic-Reset state. While in the IDLE state, bus cycle state machine 358 performs no operations, but is sensitive to bus cycle requests from the JTAG interface. If a bus cycle request is detected, state machine 358 asserts bus request (the HDT_HOLD signal) and steps into the HOLD state. While in the HOLD state, the bus cycle state machine samples the bus grant signal, namely HDT_HLDA. When a bus grant signal is received, state machine 358 takes control of local bus 30 and then transitions to the HOLD1 state. The state machine transitions to the T1 state one cycle later and then transitions to the T2 state. The requested bus cycle is actually performed in the T1 and T2 states. More particularly, in the T1 state, address information is propagated to the device (or memory) upon which the requested bus cycle is to act. In the T2 state, data is propagated to or from the device (or memory) which was addressed in the T1 state. The bus cycle which is performed is a conventional bus cycle as described in the Am486 DX/DX2 Microprocessor Hardware Reference Manual published by Advanced Micro Devices, Rev. 1, 1993, for example in Chapter 7 thereof. More information with respect to the standard T1 and T2 states is provided in this Am486 Reference Manual. When the bus cycle is completed as indicated by the RDY or BRDY, and BLAST signals, the state machine returns to the IDLE state.

A STOP command causes state machine 358 to stop CPU execution. This is achieved by requesting local bus 30. When this occurs, CPU bus cycles stop immediately and internal CPU activity stops as soon as the CPU requires external data to continue. As seen in FIG. 6, in response to the STOP CPU command the state machine asserts the bus request (HDT_HOLD) signal and transitions to the HOLD2 state. The state machine waits in the HOLD2 state until bus grant (HDT_HLDA) is detected and then transitions into the HLDA state. The state machine can remain in this HLDA state indefinitely during a debug session. While in this state, state machine 358 can perform bus cycles, allow the CPU to perform single bus cycles, or issue control commands. When the STOP CPU request is eventually removed, the state machine will return to the IDLE state.

Bus cycles are initiated from the HLDA state as just described. As seen in the state diagram of FIG. 6, in response to a bus cycle request, the state machine transitions to the HOLD1 state and then to the T1 and T2 states where the requested bus cycle is performed. The state machine then proceeds back to the HLDA state after performance of the requested bus cycle. In this instance, the state machine does not need to acquire local bus 30 before the cycle and does not release bus 30 after the cycle.

CPU 20 is permitted to single step by returning control of bus 30 to CPU 20 for one clock cycle. In response to a Single Step request, the state machine drops HDT_HOLD and transitions to the CYCLE state. Since other requests may be in the system at this time, the state machine monitors the CPU_HOLD signal (or all of the system requests) and waits until CPU_HOLD goes away for one clock cycle. The state machine then asserts HDT_HOLD and transitions into the HOLD2 state. The state machine then waits in the HOLD2 state until HDT_HLDA is detected and then returns to the HLDA state.

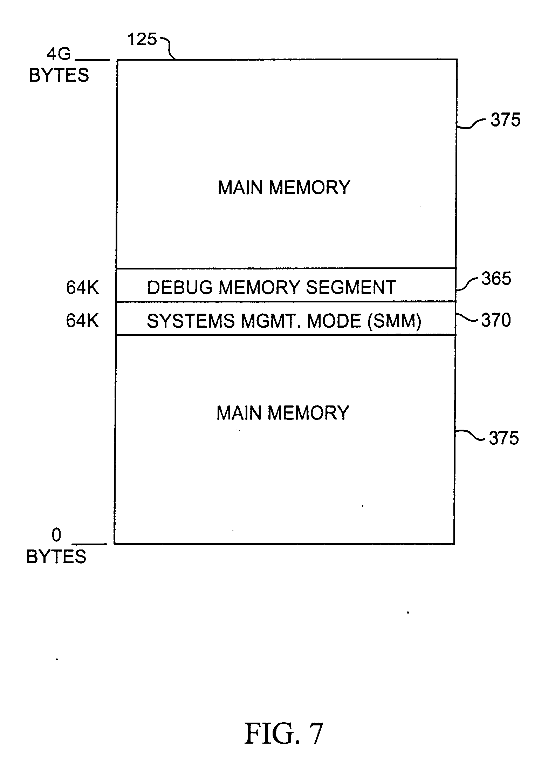

FIG.7 is a representation of the memory space in main memory 125 of FIG. 2. In this particular embodiment, main memory space spans from zero to 4 Gigabytes. Two reserved memory areas are indicated in FIG. 7, namely debug memory area 365 and a systems management mode (SMM) memory area 370. The remainder of memory 125 is designated as main memory 375. Whereas prior microprocessor memory systems employ a reserved SMM area for systems management purposes, such as power saving for example, the present invention includes a special debug memory area 365 in addition to the SMM memory area 370. Debug memory area 365 is employed to store debug software. In this particular embodiment, both the debug memory area 365 and the SMM memory area 370 employ 64K reserved memory segments. Other size memory areas may be employed as well.

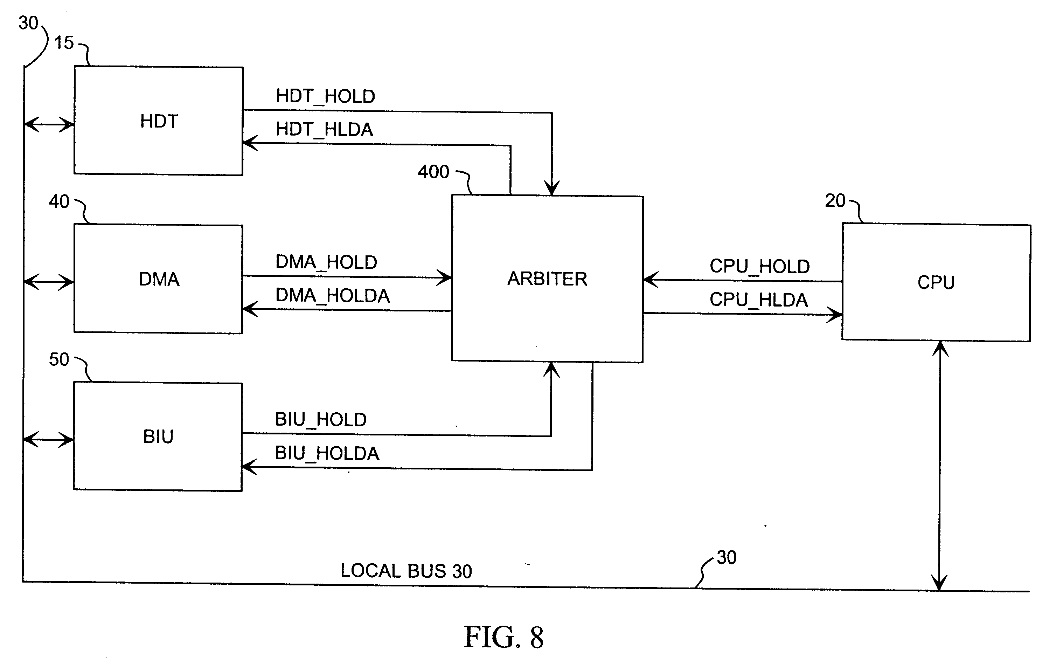

It is noted that microprocessor 10 includes a conventional arbitration circuit or arbiter 400 as shown in FIG. 8 for determining which particular functional unit is granted access to local bus 30 at any particular time. FIG. 8 shows arbiter 400 coupled to HDT 15, DMA 40, BIU 50 and CPU 20, all of which are coupled to local bus 30. HDT 15, DMA 40, BIU 50 and CPU 20 all contend for local bus 30. When HDT 15 desires access to local bus 30 as a bus master for that bus, HDT 15 sends an HDT_HOLD signal to arbiter 400. If arbiter 400 determines that CPU 20, DMA 40 and BIU 50 do not require access to local bus 30 at this point in time, then CPU 20 sends an HDT_HLDA signal (hold acknowledge) signal to HDT 15 at the end of the current local bus cycle. In a similar manner, CPU 20, DMA 40 and BIU 50 request access to local bus 30 by sending CPU_HOLD, DMA_HOLD and BIU_HOLD signals, respectively, to arbiter 400. Arbiter 400 grants access to local bus 30 to CPU 20, DMA 40 and BIU 50 by sending CPU_HLDA, DMA_HLDA, and BIU_HLDA signals, respectively, to such functional units. Thus, when state machine 358 asserts HDT_HOLD to arbiter 400, an HDT_HLDA hold acknowledge signal is sent to HDT 15 to grant HDT 15 access to local bus 30 when that bus is available.

When HDT 15 receives the HDT_HLDA signal, bus cycle state machine 358 asserts signals M/IO#, D/C#, W/R#, BLAST#, ADS#, MEM_MODE, ADDR and BE# on local control bus 360 of local bus 30. The particular bus transaction (memory read, memory write, I/O read, I/O write, for example) specified by state machine 358 is carried out. The functional units of integrated processor 10 respond to the assertion of the above signals by transmitting RDY# or BRDY# to acknowledge completion of the bus transaction when such units perform a bus transaction. For example, memory controller 35 generates a BRDY# when it completes a memory read bus transaction.

After receiving RDY# or BRDY#, the bus cycle state machine 358 returns to an idle state awaiting a new signal START from opcode decoder 357 which would signify the decoding of a new command. In other words, at this point HDT 15 and opcode decoder 357 are waiting to receive another command from host 200 for decoding and processing.

In arbitration, whichever master initiates a bus transaction waits for a ready signal from the functional unit it is seeking to communicate with. For example, when HDT 15 is attempting to perform a memory read and memory controller 35 is ready with the requested data, memory controller 35 sends a RDY# or BRDY# to HDT 15. HDT 15 then picks up the requested data which is available of local bus 30.

### IV. Hardware/Software Test Tool - Detailed Operation DEBUG MODE

In one embodiment of the invention, CPU 20 executes debugging software which is installed in debug memory area 365. For example, a commercially available debugger program such as Turbo Debug from Borland, Inc. may be employed. More particularly, the debug kernel from such program is stored in debug memory area 365 and the user interface portion of the program is stored in host 200. When this debug software in memory area 365 is being executed, the system is said to be in debug mode. The debugging software is used for debugging applications which run on the target, and can also be used in low level (early development stage) memory tests, for example.

Once HDT 15 causes CPU 20 to enter debug mode, the CPU is capable of interpreting debug commands. In other words when HDT 15 enters this command interpreting debug mode, the CPU can execute the debug commands featured by the particular debugger program. For example, when the Turbo Debug kernel is employed in debug memory area 365 as the debugger program, the CPU can respond to the following debug commands of Table 6:

**Table 6**

| DEBUG COMMANDS |
|---|
| - read and write a CPU internal register; |
| - single step through a program; |
| - prepare to execute a program; |
| - standard commands; |
| - other debugger-specific commands. |

These sample debug commands are given by way of example and not by way of limitation. Other debug commands in addition to those listed above may also be employed.

Initially, the entire debug software program including both the debug kernel and the user interface portion is stored in host 200 in a non-volatile storage media. Each time target system 100 is turned on and host system 200 is booted up, the debug kernel is transmitted or downloaded from host 200 over JTAG bus 205 to target 100. When the debug kernel arrives at target 100, it is stored in special debug memory area 365. The debug kernel which is downloaded into debug memory area 365 includes a command decode and execute section, a debug interrupt handler and a breakpoint handler. In this particular embodiment, the entry point for the debug kernel in memory 365 is 000FFF0. Once loaded in memory area 365, the debug kernel establishes a communications protocol with the host from which it is then capable of receiving debug commands from the debug user interface portion on the host. The host communicates with the target system's debug kernel by using arbitrarily chosen, but specific memory locations in debug memory area 365. The host writes command information in the debug space via JTAG bus 205. Once the command is carried out, the result is stored in the debug memory area. The host then obtains the result or responsive information from the debug kernel by reading from the debug memory space. Again, communication between the debug kernel of target 100 is over JTAG bus 205. The above arrangement of debug memory space 365 permits host 200 to send commands to HDT 15 and receive results from HDT 15 without being intrusive on normal microprocessor operations since both the commands and results are stored outside of normal main memory space.

When CPU 20 is executing debug code in debug memory area 365, it is said to be in the debug mode. In one embodiment of the invention, there are three ways for the CPU to enter the debug mode.

When the CPU encounters one of the three conditions which cause it to enter debug mode, it saves the contents of the CPU registers to main memory 125 for later recall. The CPU then looks to the debug memory segment 365 and executes the code that it finds there, namely the debug kernel. When the debug kernel is executed, the HDT can 1) examine and modify internal processor (CPU) registers 2) cause the CPU to resume execution at a specific location 3) set a breakpoint in the software application that is presently being executed by the CPU and which is being debugged, and 4) perform single stepping through such software applications. These functions are available in the debug kernel. Results from these operations, if any, are stored in the debug memory segment 365 for later retrieval by host 200.

The first way for the CPU to enter the debug mode is for HDT 15 to receive a specific command from host 200 which instructs HDT 15 to generate a debug interrupt. More specifically, host 200 sends HDT 15 a Write Control Register command including a HDT control command (DBGINTR, see Table 5) which forces HDT 15 and CPU 20 into the debug mode. A debug interrupt is thus said to be issued which causes the CPU to enter the debug mode. In this case, the CPU has entered debug mode upon request as opposed to automatically upon encountering a predetermined condition.

A second way that debug mode can be entered is via address matching. As seen in FIG. 1, CPU 20 includes four debug registers, namely registers DR1, DR2, DR3 and DR4. Selected addresses of interest to the test operator are stored in these debug registers. If the address of the current line of code which is presently being executed matches the contents of any of the four debug registers DR1, DR2, DR3 and DR4, then debug mode is entered by the CPU.

A third way for CPU 20 to enter the debug mode is for CPU 20 to encounter a debug instruction in the course of normal execution of an application. For example, this would occur when a debug instruction is inserted in an application program by debugger software such as Turbo Debug by Borland, Inc. Microprocessors such as the Am486 are programmed to recognize the debug instruction and to enter a debug state when such an instruction is encountered.

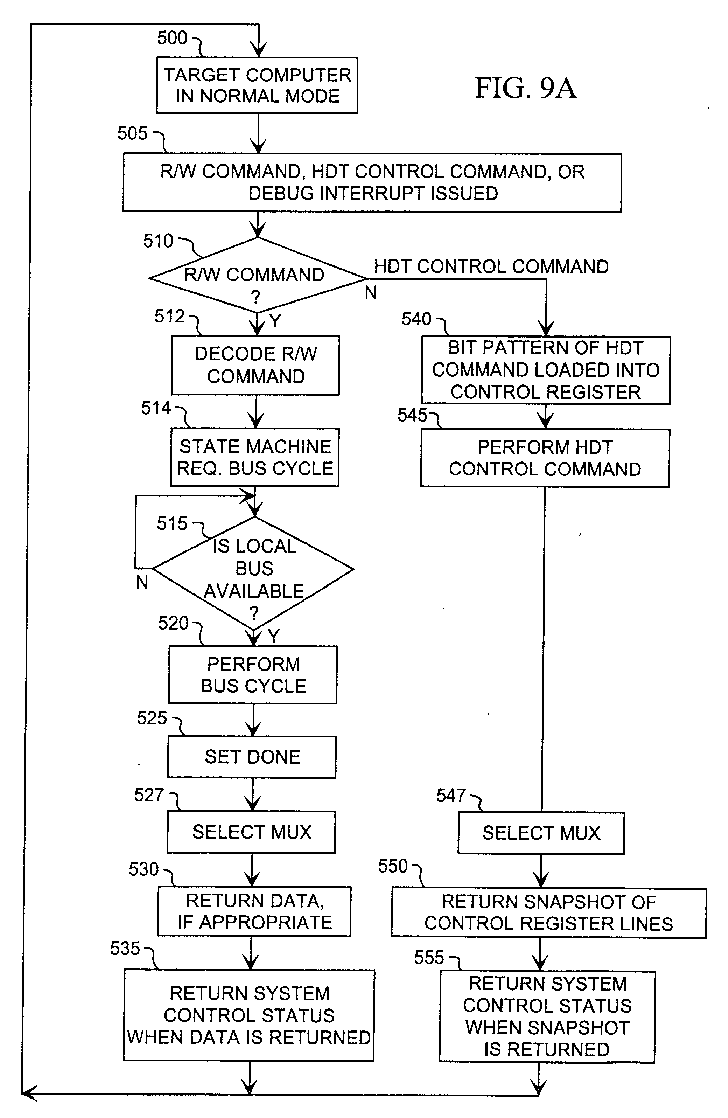

As a prelude to discussing the flow diagram of FIG. 9A-9B, it is noted that there are two ways for commands to be carried out by HDT 15. These two ways correspond to the two different types of commands, namely debug commands as defined in Table 6 and so-called built-in commands/control commands as defined in Tables 1 and 5.

With respect to debug commands which are carried out in debug mode, host 200 communicates with the target computer's debug kernel which is stored at a predetermined memory location in the debug memory segment or debug memory space 365. The host writes a debug command via JTAG bus 205 to this debug memory space. Once a debug command has been so written to the debug space, it is available for processing by the target CPU. The debug kernel carries out the particular command and stores responsive information, namely the result, in the debug memory space for later retrieval by the host computer. To retrieve this result information, the host computer reads the result from the debug space via the JTAG bus. The host computer thus receives result information back from the debug kernel.

With respect to built-in commands, namely those which initiate bus cycles and related activities set forth in Table 1, these commands can be carried out in either normal mode or debug mode. Likewise, the HDT control commands listed in Table 5 can be carried out in either normal mode or debug mode. Normal mode refers to those times when target computer 100 is not in debug mode. Typically, normal mode includes those times when target computer 100 is executing an application program or is idle.

### V. Operational Flow

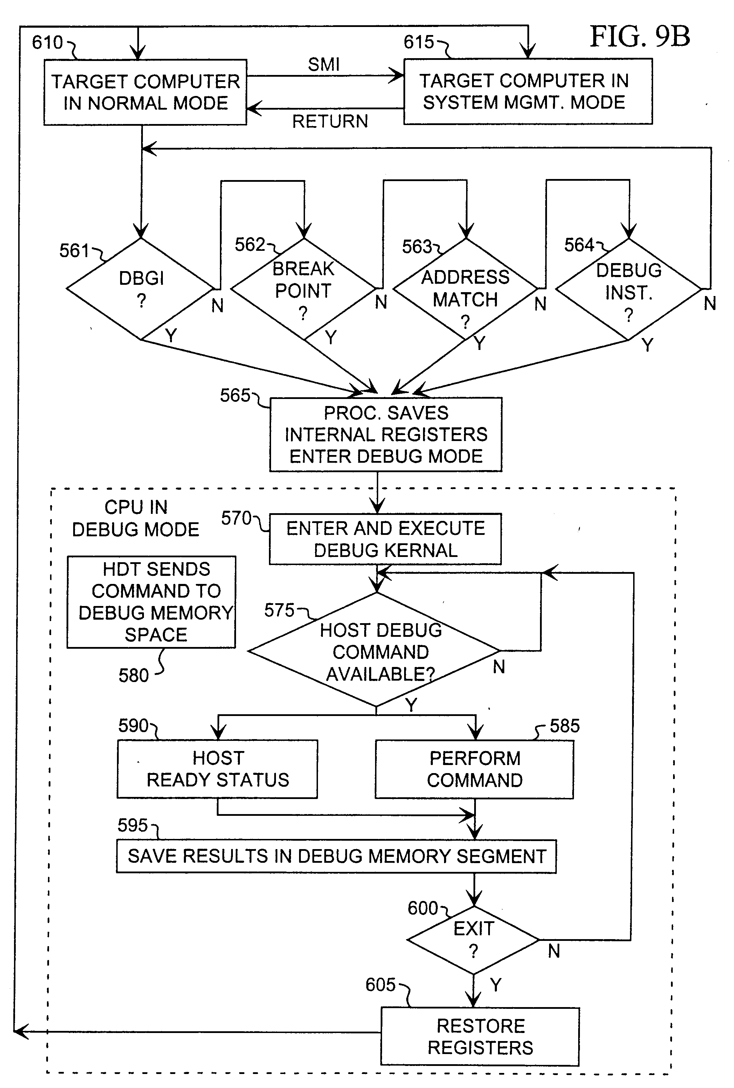

FIG. 9A and FIG. 9B together form a flow diagram depicting the operational flow of the system which includes target computer 100 and host computer 200. For clarity, FIG. 9A is directed mainly to HDT operations wherein HDT 15 receives commands from the host 200 and so-called "primitive" operations, such as reads and writes, are performed by the HDT on the local bus. FIG. 9B is directed mainly to those system operations wherein CPU 20 is called upon to execute the debug kernel which is stored in debug memory segment 365 and wherein the CPU performs debug functions, such as modifying internal microprocessor registers, for example.

Referring now to FIG. 9A, it is assumed that target computer 100 is initialized and is operating in the normal mode in block 500. In normal mode, CPU 20 is typically executing application software or is idle. An HDT R/W command (read/write command), an HDT control command or an HDT debug interrupt is issued or occurs at block 505. A test is then conducted at decision block 510 to determine if HDT 15 has issued an R/W command (read/write command) or an HDT control command.

If an R/W command (ie. a built-in command) is detected at block 510, then such command is decoded at block 512 to determine which particular R/W command has been received. State machine 358 then requests a bus cycle by issuing the appropriate bus cycle control signals on local control bus 360 to cause the local bus transaction specified in the decoded R/W command to be initiated on local bus 30 as per block 514. A test is conducted at block 515 to determine if local bus 30 is available to carry out the particular bus cycle specified in the decoded R/W command. If local bus 30 is not available, then HDT 15 waits until bus 30 is available. When local bus 30 becomes available, then the specified bus cycle is performed as per block 520. A DONE signal is then generated when the bus cycle has been performed to signify that the bus cycle is complete. If the specified local bus operation is one where data is returned, as for example in the case of a memory read, then such data is returned to host 200 over JTAG bus 205 in block 530. For this data return to occur, MUX 350 is switched to couple data-in register 345 to the address/data portion 310 of shift register as per MUX select block 527. The system control status signals, DONE, HOLD, INTR, DBGI#, SMI# and INTR_MODE are returned as well to host 200 at block 535 along with the return data. Process flow then continues back to block 500 with target 100 being in the normal mode.

If a determination was made at decision block 510 that an HDT control command is present, then as per block 540 the bit pattern of the HDT control command is loaded into control register 320 and is placed onto control bus 22 to initiate the function specified in the control command. The function specified in the control command is performed at block 545. A snapshot of the control register 320 lines is returned to host 200 at block 550. In more detail, when a Select Control Register command is received by HDT 15, the MUX select signal provided to MUX 350 causes the control register 320 output to be coupled through to address/data portion 310 of shift register 300 as per MUX select block 547. In this manner, the control register line snapshot is returned to host 200 at block 550. At the same time that the control register line snapshot is returned, the system control status signals DONE, HOLD, INTR, DBGI#, SMI# and INTR_MODE are returned as well to host 200 at block 555. Process flow then continues back to block 500 with target 100 being in the normal mode.

While not shown graphically in the flowchart of FIG. 9A, it is noted that whenever microprocessor 10 is in normal mode as in FIG. 9A, microprocessor 10 still continually checks to see if a debug interrupt condition exists as indicated in FIG. 9B. More particularly, the presence of four conditions is tested at decision blocks 561, 562, 563 and 564. Decision block 561 checks to see if a debug interrupt command DBGI has been issued by host 200 to microprocessor 10. The issuance of such a command will place microprocessor directly in debug mode. A test is also made at decision block 562 to determine if the instruction presently being executed is a breakpoint, and if so, microprocessor 10 enters debug mode. Moreover, a test is performed at decision block 563 to determine if the address of the instruction currently being executed matches the contents of any one of the four debug registers DR1, DR2, DR3 and DR4. If such a match occurs, debug mode is entered. Another test is conducted at decision block 564 to determine if the instruction currently being executed by the microprocessor is a debug instruction, and if so, debug mode is entered.

More specifically, if any of tests 561-564 are answered in the affirmative, the processor saves the contents of its internal registers to main memory at block 565 and enters debug mode. The debug kernel which is stored in the special memory segment 365 is then entered and executed at block 570 as the processor enters debug mode.

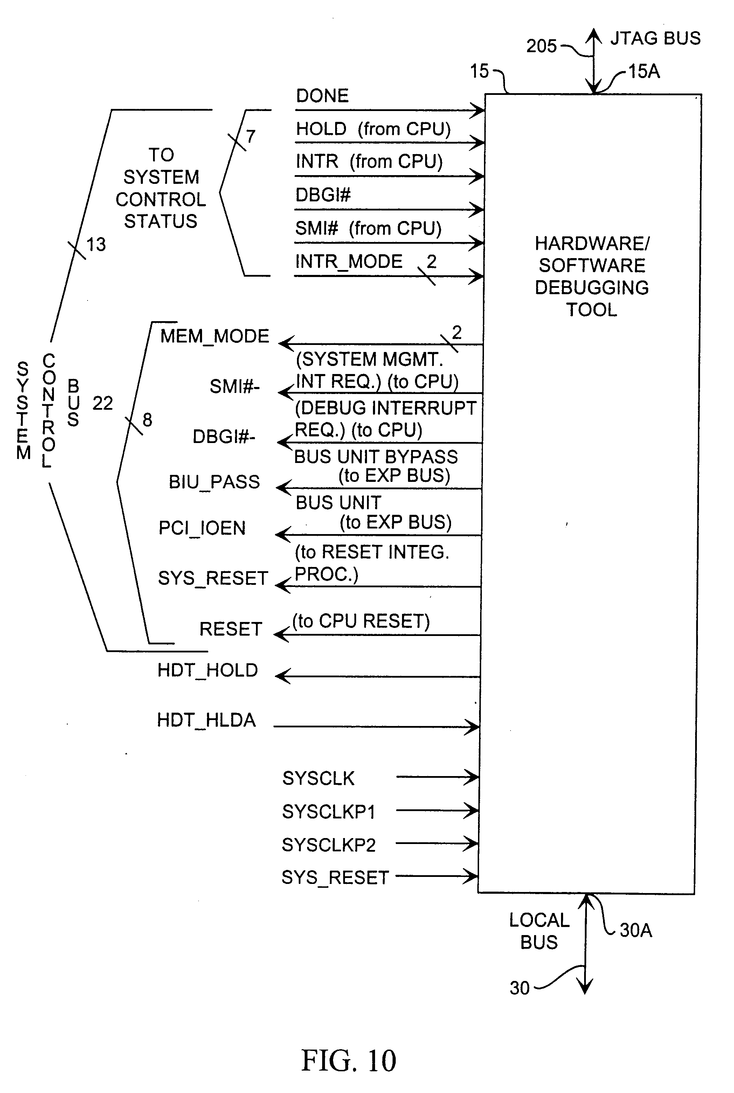

A test is then conducted at decision block 575 to determine if a host debug command is available. In other words, HDT 15 looks to see if any Table 6 debug commands have been received from host 200. A floating block 580 is used to indicate that the processor is continually looking to see if HDT 15 has sent a command to debug memory space. Once a host command appears, the host command is performed or executed at block 585 and simultaneously therewith the host ready status is prepared at block 590. That is, if host 200 is ready to send another command to HDT 15, it so indicates by sending an appropriate host ready status signal to HDT 15 over JTAG bus 205. The next debug command is then sent to HDT 15 and is then performed by HDT 15. Results, if any, from CPU 20 and associated devices in response to debug commands are stored in debug memory segment 365 as per block 595. Host 200 retrieves these results using the JTAG bus 205. When host 200 is done sending debug commands to HDT 15, host 200 sends an exit command to HDT 15. A test is conducted at decision block 600 to determine if it is appropriate to exit the debug mode. If an exit command is not detected at decision block 600, then process flow continues back to the host command available block where the next command from host 200 is processed. However, if an exit command is detected at decision block 600, then the internal registers of CPU 20 are restored at block 605 and process flow continues back to block 610 at which HDT 15 and target computer 200 reenter the normal mode. CPU 20 is said to be in debug mode throughout blocks 570-605. When the processor re-enters the normal mode at block 610, the processor can be placed in system management mode (block 615) by issuing a system management interrupt thereto. Once back in normal mode, the processor continues to check for the presence of any R/W commands or HDT control commands (block 510) as in the flow diagram of FIG. 10A and also continues to check for the presence of any of the four conditions (blocks 561-564) which initiate debug mode as in the flow diagram of FIG. 9B.

It is noted that the R/W commands (built-in commands) which are performed on the leftmost path in the flow diagram of FIG. 9A are advantageously performed without CPU involvement. This is especially beneficial in the early stages of system development of a target computer 100 when all of the components of the target computer may not be yet totally functional. In contrast, the debug commands which are performed in the flow diagram of FIG. 9B do require CPU involvement. More particularly, debug commands are actually executed by CPU 20 and results are passed back to host computer 200 via the debug memory space 365. The built-in commands are used to pass the debug commands to the CPU.

### VI. Bus Structures And HDT Pinouts

Returning momentarily to the case where one of the built-in commands of Table 1 is being executed by HDT 15, it will be recalled that the bus cycle specified in the command is carried out and that a result is returned over local bus 30. In the case of a read, the data that is read from memory is returned as a result, In addition, a snapshot of local bus 30 is returned to host computer 20. This snapshot includes a JTAG Status Return which is defined as information with respect to the current state of the first six internal system control bus signals given above in Table 5A (ie. bits 32-38) and the contents of control register 320 (stored in shift register locations 0-21 with unused locations being zeroed.)

FIG. 10 is a diagram showing the pin-out of HDT 15 including the JTAG serial interface or port 15A, local bus interface 30A, the remaining pins of HDT 15 being the control interface thereof, namely system control bus 22.

The pin-out of JTAG interface 15A is conventional and is represented by the following pins of HDT 15 given in Table 8.

**Table 8**

| JTAG INTERFACE | |
|---|---|
| Pin Name | Function |
| CLOCKHDT | :IN; -- Clock Phase 1 |
| CLOCKHDTF | :IN; -- Clock Phase 2 |
| SHIFTHDT | :IN; -- Shift/Load control |
| UPDATEHDT | :IN; -- Copy shift register to destination |
| HDT_TDI | :IN; -- Input serial data |
| HDT_TDO | :OUT; -- Output serial data |

The Local Bus interface 30A is represented by the following pins of HDT 15 given in Table 9. As discussed earlier, local bus 30 couples CPU 20 to HDT 15 and other system components as shown in FIG. 1. Local bus 30 includes the following lines listed in Table 9. It is noted that CPU 20 and HDT 15 each include pins having labels corresponding to the following lines of local bus 30 set forth in Table 9.

**Table 9**

| LOCAL BUS PINOUT | |
|---|---|
| Pin Name | Function |
| SYSCLK | :IN; -- System clock |
| SYSCLKP1 | :IN; -- Clock phase 1 |
| SYSCLKP2 | :IN; -- Clock phase 2 |
| SYS_RESET | :IN; -- Synchronous system reset |
| A31:A0 | :OUT; -- Memory or I/O addresses |
| D31:D0 | :IN/OUT -- Memory or I/O data |
| BE3#:BE0# | :OUT -- Byte enables |
| M/IO# | :OUT -- Memory (high) or I/O |
| D/C# | :OUT -- Data (high) or Code (low) |
| W/R# | :OUT -- Write (high) or Read (low) |
| ADS# | :OUT -- Address Strobe |
| EADS# | :OUT -- Cache Invalidate Address Strobe |
| BLAST# | :OUT -- Last cycle of burst (low). |
| RDY# | :IN -- Responder Ready, Single Cycle |
| BRDY# | :IN -- Responder Ready, Burst Cycle |
| KEN# | :OUT -- CPU Cache Enable |
| FLUSH# | :OUT -- Flush CPU Cache |

The pins and lines listed above for local bus 30 from A31:A0 through FLUSH# are standard to the Am486 microprocessor which is manufactured by Advanced Micro Devices, Inc. and described in the Am486 DX/DX2 Microprocessor Hardware Reference Manual, Rev. 1, 1993 published by Advanced Micro Devices, Inc. The signals SYSCLK, SYSCLK1 and SYSCLK2 are clocking signals which are supplied to HDT 15 to provide clocking to the components thereof.

System control bus 22 couples CPU 20 to HDT 15 as set forth in the pinout listed in Table 10. It will be recalled that control register 320 drives these system control bus lines and that a snapshot of these lines without the MEM_MODE signal is provided back to host 300 through the cooperation of MUX 350, address/data portion 310 of shift register 300 and JTAG bus 205.

**Table 10**

| SYSTEM CONTROL BUS | |
|---|---|
| Pin Name | Function |
| HOLD | :IN -- System wide Hold Request |
| INTR | :IN -- Interrupt Request |
| DBGI# | :OUT -- DBI Request |
| SMI# | : -- SMI Request |
| INTR_MODE | :IN -- Operating Mode of the CPU (2 bit signal) |
| MEM_MODE | :IN -- Operating Mode of the current memory cycle from CPU (2 bit signal) |
| BIU_PASS | :OUT -- Instruct BIU to pass all cycles to the PCI bus (expansion bus) |
| PCI_IOEN | :OUT -- Instruct BIU to respond to I/O requests from external initiators |
| SYS_RESET | :OUT -- Reset System |
| RESET | :OUT -- Reset CPU |

The following two signals relate to the control of local bus arbitration, but are grouped separately from system control bus 22.

| | |
|---|---|
| HDT_HOLD | OUT -- HDT Hold Request |
| HDT_HLDA | :IN -- HDT Hold Acknowledge |

It is noted that CPU 20 and HDT 15 each includes pins having labels corresponding to the following control lines of system control bus 22.

The control lines listed above in Table 10 for system control bus 22 are standard to the Am486 microprocessor which is manufactured by Advanced Micro Devices, Inc.(AMD) and which is described in the AMD publication Am486 DX/DX2 Microprocessor Hardware Reference Manual, Rev. 1, 1993.

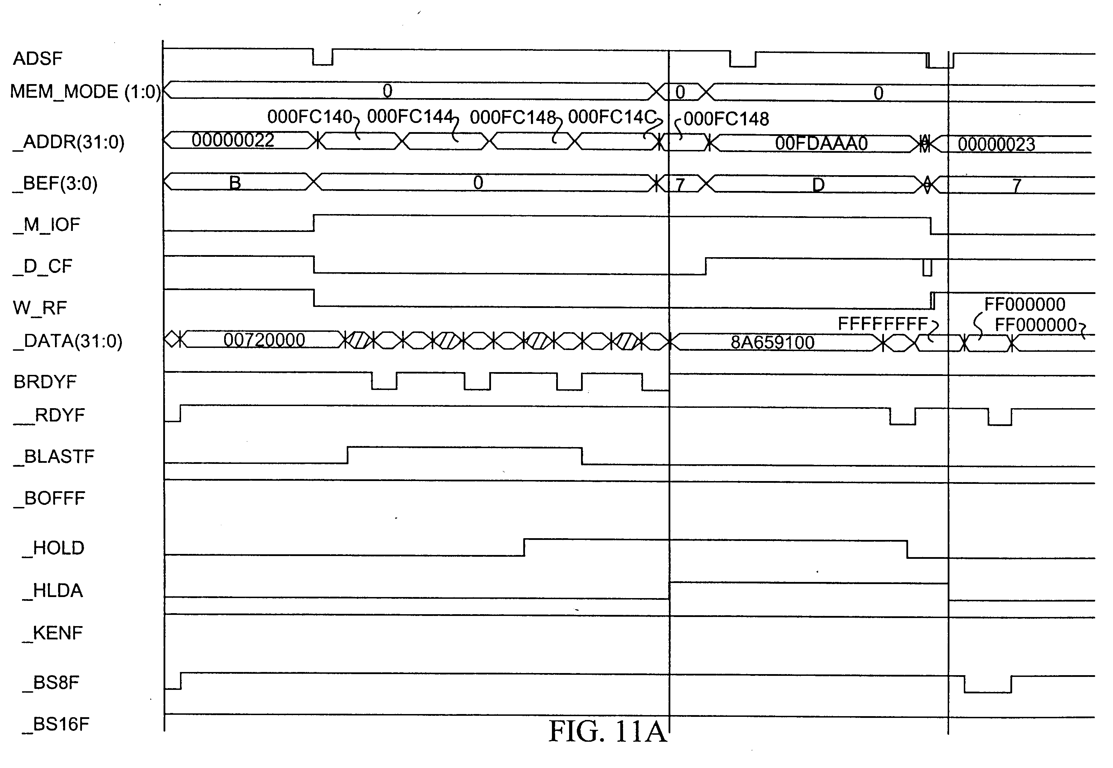

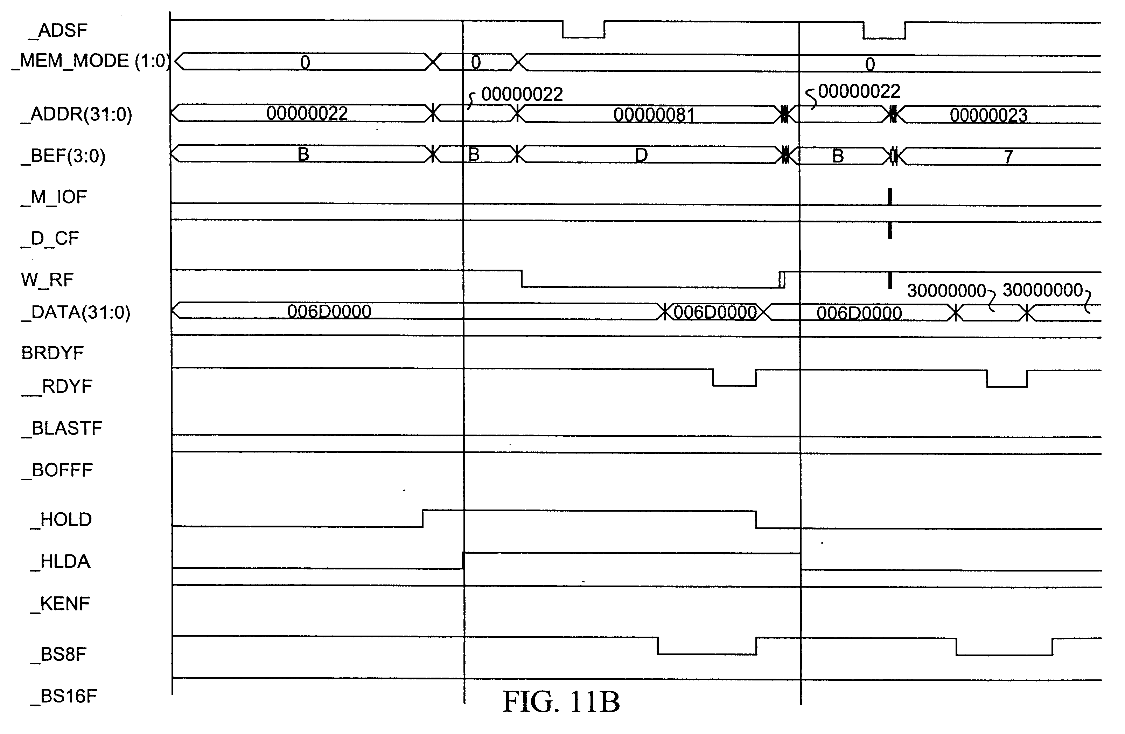

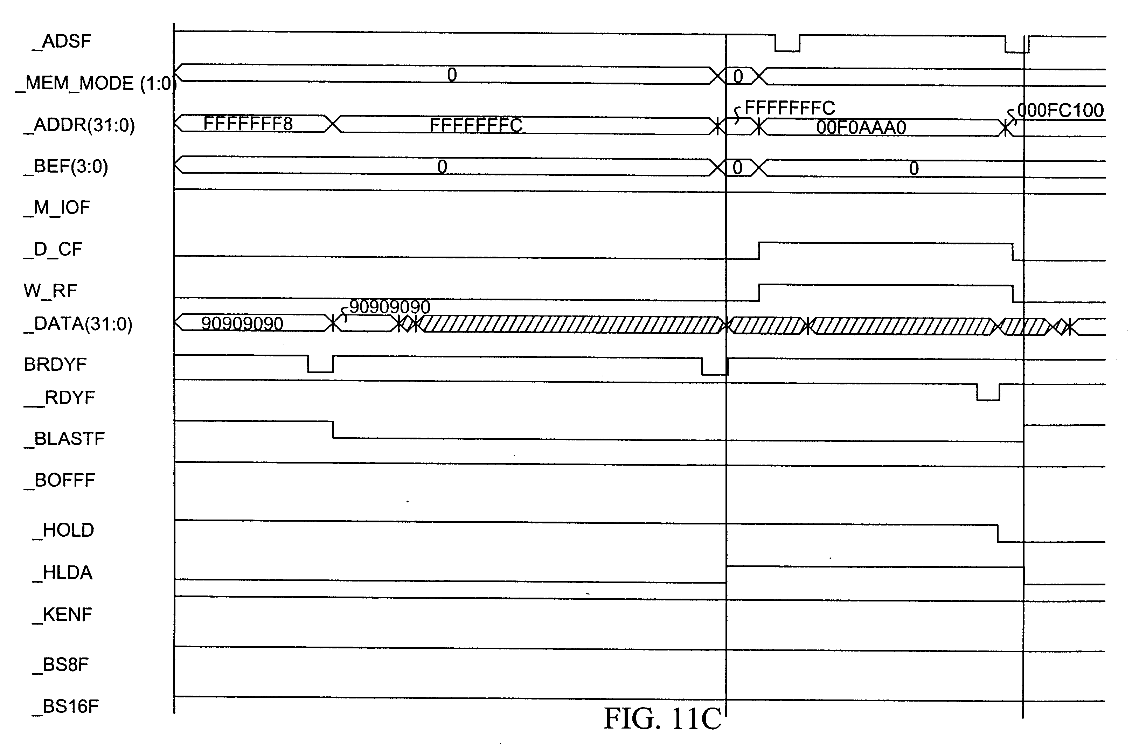

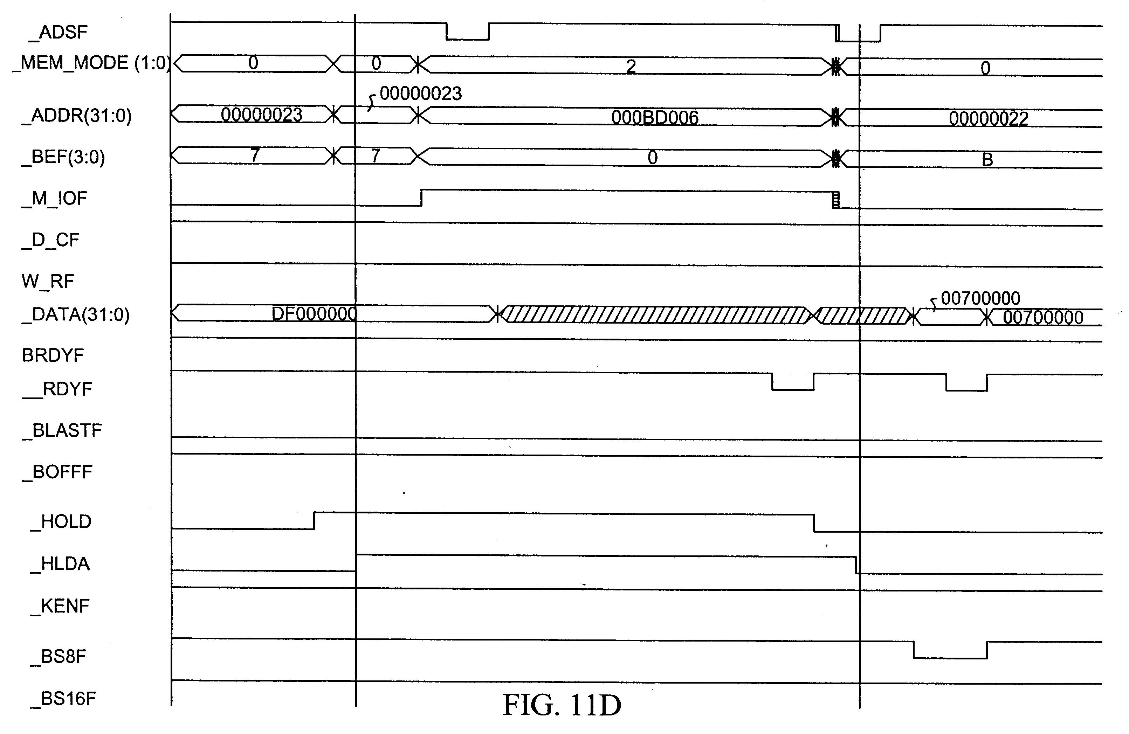

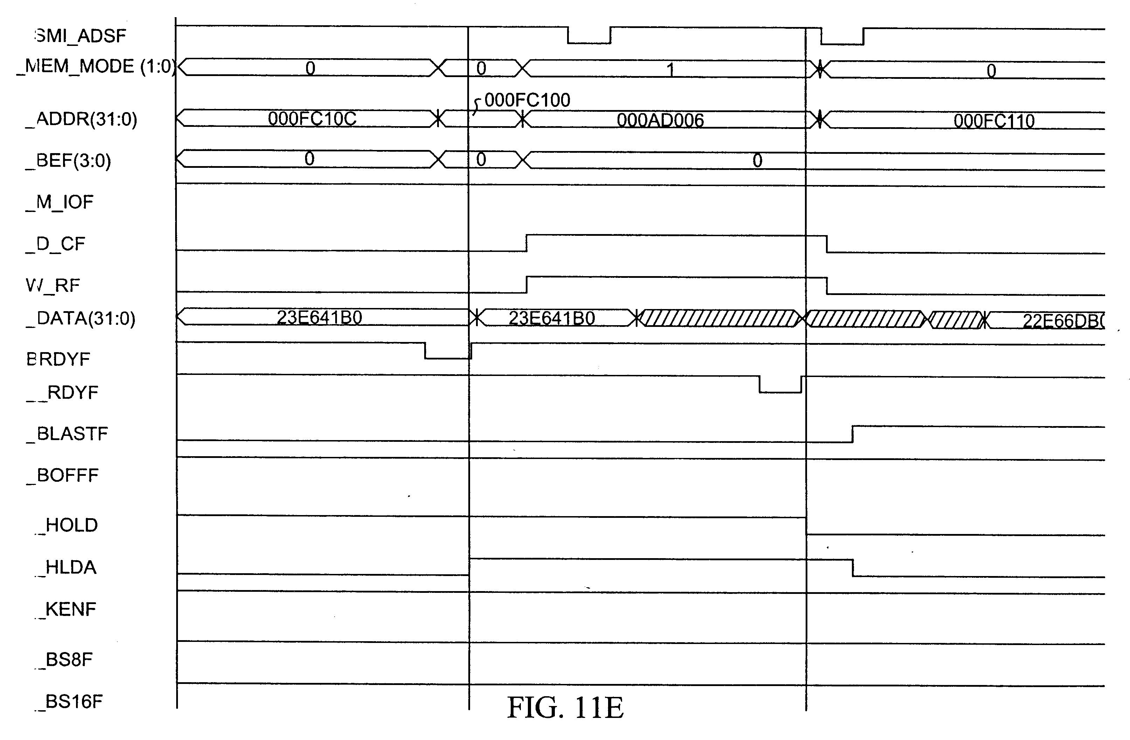

FIG. 11A-11E shows a series of timing diagrams illustrating the signals on local bus 30 while HDT 15 is being operated. More particularly, FIG. 11A shows local bus signals when HDT 15 is performing a memory read bus cycle in normal mode. FIG. 11B shows local bus signals when HDT 15 is performing an I/O read bus cycle during normal mode. FIG. 11C shows local bus signals when HDT 15 is performing a memory write bus cycle during normal mode. FIG. 11D shows local bus signals when HDT 15 is performing a memory write in system debug mode. FIG. 11E show local bus signals when HDT 15 is performing a data write in SMM, system management mode.

While the above description sets forth an integrated processor apparatus with on-board testing capability, it is clear that a method of testing the integrated processor and associated devices is also disclosed. More particularly, a method is provided for testing an integrated processor which includes a die on which a CPU and at least one functional unit are situated. The CPU and functional unit are coupled together by a local bus. The method includes the step of providing the processor with a testing circuit which is situated on the die and which is coupled to the local bus. The method also includes the step of sending a test command to the testing circuit from a host computer external to the integrated processor. The method further includes the step of receiving the test command by the testing circuit thus resulting in a received test command. The method still further includes the step of generating a local bus cycle, by the testing circuit, in response to the received test command to provide testing of the processor and devices coupled thereto.

The foregoing has described an integrated microprocessor including a built-in testing capability. The integrated microprocessor test system is capable of testing the components of an integrated microprocessor and devices coupled thereto. Advantageously, the test system provides such testing throughout the multiple stages of microprocessor computer system development, that is, from prior to achievement of system booting all the way through operating system load and application software development.

While only certain preferred features of the invention have been shown by way of illustration, many modifications and changes will occur. It is, therefore, to be understood that the present claims are intended to cover all such modifications and changes which fall within the true spirit of the invention.

## Claims

**1.** An integrated microprocessor comprising:
a semiconductor die;
a central processing unit situated on said die;
a local bus situated on said die and coupled to said central processing unit;
at least one functional unit situated on said die and coupled to said local bus; and
a testing circuit, situated on said die and coupled to said local bus, for initiating a local bus cycle for testing purposes in response to a test command originating external to said microprocessor.

**2.** The integrated microprocessor of claim 1 wherein said testing circuit further includes decoding means for decoding a type of bus cycle set forth in said command.

**3.** The integrated microprocessor of claim 2 wherein said testing circuit further includes a bus cycle state machine for generating the type of bus cycle indicated by said command.

**4.** An integrated microprocessor comprising:
a semiconductor die;
a central processing unit situated on said die;
a local bus situated on said die and coupled to said central processing unit;
at least one functional unit situated on said die and coupled to said local bus;
a memory, coupled to said local bus, said memory including a debug memory space for storing debug software, and
testing means, situated on said die and coupled to said local bus, said testing means being operative in a bus cycle mode for initiating local bus cycles to test said microprocessor and functional units coupled thereto in response to test commands originating external to said microprocessor, said testing means being operative in a debug mode for executing said debug software which is stored in said debug memory space.

**5.** The integrated microprocessor of claim 4 wherein said testing means further includes decoding means for decoding a type of bus cycle set forth in said command.

**6.** The integrated microprocessor of claim 4 wherein said testing means includes debug mode command detecting means for detecting when said microprocessor receives a test command including a debug mode request.

**7.** The integrated microprocessor of claim 4 further comprising:
at least one debug register situated in said central processing unit,
said microprocessor including address matching means for determining when a match occurs between an address stored in said debug register and an address of an instruction which is currently being executed, said microprocessor entering said debug mode when said match occurs.

**8.** The integrated microprocessor of claim 4 further comprising:
debug instruction sensing means, situated in said central processing unit, for detecting when a currently executed instruction is a debug instruction such that said microprocessor enters said debug mode when said debug instruction is detected.

**9.** A computer development system comprising:
a target computer including an integrated microprocessor having
a semiconductor die;
a central processing unit situated on said die;
a local bus situated on said die and coupled to said central processing unit;
at least one functional unit situated on said die and coupled to said local bus,
a peripheral device coupled to said local bus;
a memory coupled to said central processing unit and including a debug memory space for storing debug software;
testing means, situated on said die,and coupled to said local bus, said testing means being operative in a bus cycle mode for generating local bus cycles in response to test commands originating external to said microprocessor, said testing means being operative in a debug mode for executing said debug software which is stored in said debug memory space, and
a host computer, coupled to said target computer, for providing said testing means with test commands and for retrieving the results of said test commands from said target computer.

**10.** The integrated microprocessor of claim 9 wherein said testing means further includes decoding means for decoding a type of bus cycle set forth in said command.

**11.** The integrated microprocessor of claim 9 wherein said testing means includes debug mode command detecting means for detecting when said microprocessor receives a test command from said host computer including a debug mode request.

**12** The integrated microprocessor of claim 9 further comprising:
at least one debug register situated in said central processing unit,
said microprocessor including address matching means for determining when a match occurs between an address stored in said debug register and an address of an instruction which is currently being executed, said microprocessor entering said debug mode when said match occurs.

**13.** The integrated microprocessor of claim 9 further comprising:
debug instruction sensing means, situated in said central processing unit, for detecting when a currently executed instruction is a debug instruction such that said microprocessor enters said debug mode when said debug instruction is detected.

**14.** The integrated microprocessor of claim 9 further comprising a test bus coupling said host computer to said testing means of said target computer.

**15.** The integrated microprocessor of claim 14 wherein said test bus comprises a JTAG bus.

**16.** A method of testing an integrated processor, said processor including a die on which a CPU and at least one functional unit are situated and coupled together by a local bus, said method comprising the steps of:
providing said processor with a testing circuit coupled to said local bus and situated on said die;
sending a test command to said testing circuit from a host computer external to said integrated processor;
receiving said test command by said testing circuit thus resulting in a received test command, and
generating a local bus cycle, by said testing circuit, in response to said received test command to provide testing of said processor and devices coupled thereto.

**17.** The method of claim 16 further comprising the step of:
decoding the received test command to determine the particular type of local bus cycle specified by said received test command.

**18.** The method of claim 16 wherein said functional unit is a memory controller having a memory coupled thereto wherein
said sending step includes sending a memory write request command to said testing circuit, and
said generating a local bus cycle step includes generating a memory write bus cycle to test said memory.

**19.** The method of claim 16 wherein said functional unit is a memory controller having a memory coupled thereto wherein
said sending step includes sending a memory read request command to said testing circuit, and
said generating a local bus cycle step includes generating a memory read bus cycle to test said memory.

**20.** The method of claim 16 wherein said functional unit is a bus interface unit having an I/O device coupled thereto wherein
said sending step includes sending an I/O write request command to said testing circuit, and
said generating a local bus cycle step includes generating an I/O write bus cycle to test said I/O device.

**21.** The method of claim 16 wherein said functional unit is a bus interface unit having an I/O device coupled thereto wherein
said sending step includes sending an I/O read request command to said testing circuit, and
said generating a local bus cycle step includes generating an I/O read bus cycle to test said I/O device.

**22.** A method of testing an integrated processor, said processor including a die on which a CPU and at least one functional unit are situated and coupled together by a local bus, said method comprising the steps of:
storing debug software in a debug memory space in a memory coupled to said processor
providing said processor with a testing circuit coupled to said local bus and situated on said die;
sending a test command to said testing circuit from a host computer external to said integrated processor;
receiving said test command by said testing circuit thus resulting in a received test command, and
generating a local bus cycle, by said testing circuit, in response to said received test commands to provide testing of said processor and devices coupled thereto.

**23.** The method of claim 22 further comprising the step of:
executing said debug software which is stored in said debug memory space thus causing said processor to operate in a debug mode.

**24.** The method of claim 23 including the step of detecting when said microprocessor receives a test command from said host computer including a debug mode request, thus causing said processor to enter said debug mode.

**25.** The method of claim 23 wherein said processor includes at least one debug register, said method further comprising the step of determining when a match occurs between an address stored in said debug register and an address of an instruction which is currently being executed, said microprocessor entering said debug mode when said match occurs.

**26.** The method of claim 23 including the step of detecting when a currently executed instruction is a debug instruction such that said microprocessor enters said debug mode when said debug instruction is detected.
